(19) Europäisches Patentamt
European Patent Office
Office européen des brevets

(11) **EP 1 665 610 B1**

(12) **EUROPEAN PATENT SPECIFICATION**

(45) Date of publication and mention
of the grant of the patent:
**07.03.2012 Bulletin 2012/10**

(51) Int Cl.:
*H04L 1/00* (2006.01)     *H03G 3/30* (2006.01)
*H03G 3/20* (2006.01)

(21) Application number: **05767277.6**

(22) Date of filing: **22.07.2005**

(86) International application number:
**PCT/JP2005/013903**

(87) International publication number:
**WO 2006/013786 (09.02.2006 Gazette 2006/06)**

(54) **RECEPTION CONTROL CIRCUIT AND RECEPTION CONTROL METHOD**

EMPFANGSSTEUERSCHALTUNG UND EMPFANGSSTEUERVERFAHREN

CIRCUIT ET PROCEDE DE COMMANDE DE RECEPTION

(84) Designated Contracting States:
**DE FR GB NL**

(30) Priority: **03.08.2004 JP 2004226856**
**15.03.2005 JP 2005073106**

(43) Date of publication of application:
**07.06.2006 Bulletin 2006/23**

(73) Proprietor: **CASIO COMPUTER CO., LTD.**
**Shibuya-ku,**
**Tokyo 151-8543 (JP)**

(72) Inventors:
• **Kitayama, Yoshihito,**
**Casio Computer Co. Ltd.**
**Hamura-shi,**
**Tokyo 2058555 (JP)**

• **Okada, Kunio,**
**c/o Casio Computer Co., Ltd.**
**Hamura-shi,**
**Tokyo 2058555 (JP)**

(74) Representative: **Grünecker, Kinkeldey,**
**Stockmair & Schwanhäusser**
**Anwaltssozietät**
**Leopoldstrasse 4**
**80802 München (DE)**

(56) References cited:
**EP-A- 1 398 930**     **GB-A- 2 371 690**
**US-A- 5 999 559**     **US-A- 6 148 189**

EP 1 665 610 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention, relates to a reception, control circuit and a reception control method which are used for receiving or demodulating a signal modulated mainly by digital modulation in -a terrestrial broadcast, a CATV broadcast, a satellite broadcast and the like

At present, in a digital television broadcast, a broadcasting satellite (BS) digital broadcast using the BS and a communication satellite (CS) digital broadcast using the CS have become popular. Moreover, a terrestrial digital television broadcast has started its broadcasting from December, 2003, and it is at a transition stage from a terrestrial analog television broadcast to the terrestrial digital television broadcast now. In the terrestrial digital television broadcast, because the orthogonal frequency division multiplexing (OFDM) system is used as its modulation system, a plurality of electric waves (specifically an image, a sound, a data broadcast and the like) are multiplexed to be transmitted.

A reception apparatus receiving a signal of such a digital television broadcast is provided with an automatic gain control circuit (AGC), which adjusts the amplification degree of an amplifier circuit according to the strength of a signal level after a -signal amplification by the amplifier circuit in order that a received broadcast wave may be corrected to a stable signal even if the signal level of the broadcast wave has changed.

Document GB-A-2 371 690 describes gain control of a tuner in a radio frequency receiver for digital signals, wherein an AGC controller controls the gain of an amplifying unit (preferably an attenuator) in accordance with a detected quality of reception. Thereby a constant reception quality can be achieved, while an incoming signal is fluctuating, by controlling the gain of attenuation of a tuner's front end stage. Therefore, a change of a parameter indicating reception quality with time is determined. In a particular described embodiment, it is further detected whether the reception quality is much better than a predetermined reference level. Accordingly, the gain of the tuner can be controlled so as to be not higher than desired, in order to further save power consumption.

Moreover, in order to discriminate the degradation of the reception grade caused by the nonlinear distortion and a carrier to noise (C/N) value of an AGC in relation to AGC control, an automatic gain control circuit which detects the reception grade of a signal outputted from a demodulator circuit and performs the AGC control such as changing an amplifier which performs gain control according to a comparison result.of the reception grade and a reference level has been also proposed (see, for example, JP-Tokukai-2001-102947A).

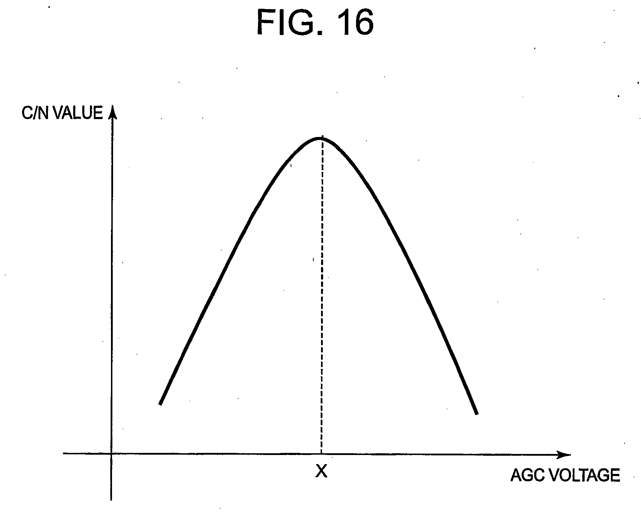

FIG. 16 is a graph showing an example of the characteristic of a C/N value to.a voltage applied to an AGC (hereinafter referred to as an "AGC voltage") in order to control an amplification degree. According to the graph, the C/N value once rises with the increase of the AGC voltage. However, when the AGC voltage exceeds X [V], the C/N value falls. The phenomenon is one generated because nonlinear distortion is generated in signal amplification by the AGC and the noises of a carrier wave are amplified. Thus, when the AGC voltage is simply increased in order to increase the C/N value, the C/N.value falls from a certain voltage value, and the optimum C/N value cannot be secured to degrade the reception grade.

However, although the invention of JP-Tokukai-2001-102947A describes AGC control in the range in which the C/N value rises with the increase of the AGC voltage (namely, X [V] or less in FIG. 16), the invention does not describe the AGC control in the range in which the AGC voltage exceeds X [V] and the C/N value falls.

When the C/N value of a signal inputted into a demodulation unit falls, it becomes impossible to perform the demodulation processing of the signal correctly, and it also becomes impossible to perform exact error correction processing in an error correction unit. The phenomena lead to the fall of the reception performance and the reliability of a terrestrial digital television broadcast reception apparatus. Accordingly, it is necessary to perform the AGC control in consideration of the changes of the C/N value in the whole AGC voltage region.

The present invention was made in consideration of the above point, and an object of the invention is to realize an improved reception control circuit and reception control method of performing the control of the amplification degree of an AGC to always secure the optimum C/N value in the neighborhood of the best C/N value in the whole AGC voltage region..

This is achieved by the features of the independent claims.

That is, in the reception control circuit or the reception control method according to the present invention, a reception grade of a received signal received in a tuner unit including an amplification unit is detected. Only when the detected reception grade does not satisfy a predetermined reference level, a change of the reception grade is detected based on the reception grade detected by a reception grade detection unit. Then, a control signal for controlling the amplification degree to rise or fall in the amplification unit of the tuner unit is outputted based on the change of the reception grade.

Because of the configuration mentioned above, the amplification degree of an amplification unit is controlled based on a change of the reception grade of a received signal. Consequently, it is possible to modify the amplification degree immediately according to a change of the reception grade, and to always secure the optimum reception grade.

Moreover, in the reception control circuit or the reception control method according to the invention, a reception grade of a received signal received by a tuner unit including a plurality of amplification units is detected. Only when the detected reception grade is detected not to satisfy a predetermined reference level, an amplification degree of at least one of the plurality of amplification

units is changed, and a change of the reception grade is detected based on the change of the amplification degree. Then control signals for controlling the respective amplification degrees in the plurality of amplification units of the tuner unit are outputted based on the change of the detected reception grade.

Because of the configuration mentioned above, it is possible to control the plurality of amplification units independently to enable the finer performance of the improvement of the reception grade. Consequently, the optimum reception grade can be always secured.

Furthermore, in the reception control circuit or the reception control method according to the invention, errors of phases and amplitudes of SP signals arranged in a way of being dispersed in a received signal received by a tuner unit including an amplification unit from previously determined phases and previously determined amplitudes, both owned by reference SP signals, are detected as a reception grade. Only when the detected errors are detected not to be zero, a change of the reception grade is detected from the reception grade detected by the reception grade detection unit, and a control signal for controlling an amplification degree of the amplification unit of the tuner unit to rise or fall is outputted based on the detected change of the reception grade.

Owing to having the configuration mentioned above, the amplification degree of the amplification unit is controlled based on the error quantities between the value of predetermined synchronization signals extracted from a received signal and reference values of the synchronization signals as the reception grade. That is, it is possible to immediately adjust the amplification degree according to a change of the reception grade as the error quantities between the values of the predetermined synchronization signals and the reference values of the predetermined synchronization signals, and to always secure the optimum reception grade.

FIG. 1 is a block diagram showing the circuit configuration of a terrestrial digital television broadcast reception apparatus according to a first embodiment;

FIG. 2 is a flowchart for illustrating the processing of an AGC voltage calculation unit according to the first embodiment;

FIG. 3 is a view for illustrating the processing of the AGC voltage calculation unit of the first embodiment;

FIG. 4 is a block diagram showing the circuit configuration of a terrestrial digital television broadcast reception apparatus according to a second embodiment;

FIG. 5 is a flowchart for illustrating the processing of an AGC voltage calculation unit of the second embodiment;

FIG. 6 is a view for illustrating the processing of the AGC voltage calculation unit according to the second embodiment;

FIG. 7 is a block diagram showing the circuit configuration of a terrestrial digital television broadcast reception apparatus according to a third embodiment;

FIG. 8 is a view showing an example of an arrangement pattern of SP signals in an OFDM symbol;

FIGS. 9A and 9B are views showing a change of the signal point of an SP signal;

FIG. 10 is a view showing a signal point arrangement of SP signals in the case of a BPSK system

FIG. 11 is a block diagram showing the circuit configuration of an SP signal error calculation unit;

FIG. 12 is a flowchart for illustrating the processing of an AGC voltage calculation unit of the third embodiment;

FIG. 13 is a view for illustrating processing of the AGC voltage calculation unit according to the third embodiment;

FIG. 14 is a block diagram showing the circuit configuration as a modified example of the third embodiment;

FIG. 15 is a block diagram showing the circuit configuration as a modified example of the first embodiment; and

FIG. 16 is the graph of an AGC voltage-C/N value characteristic.

In the following, the preferred embodiments of the preset invention are described with illustrated examples. Moreover, although the following descriptions of the embodiments are given to the case where a reception circuit according to the present invention is applied to a terrestrial digital television reception apparatus, it is needless to say that the present invention may be applied to reception apparatuses for receiving terrestrial digital broadcasts such as a BS digital television broadcast, a CS digital television broadcast and a terrestrial digital broadcast by CATV.

[First Embodiment]

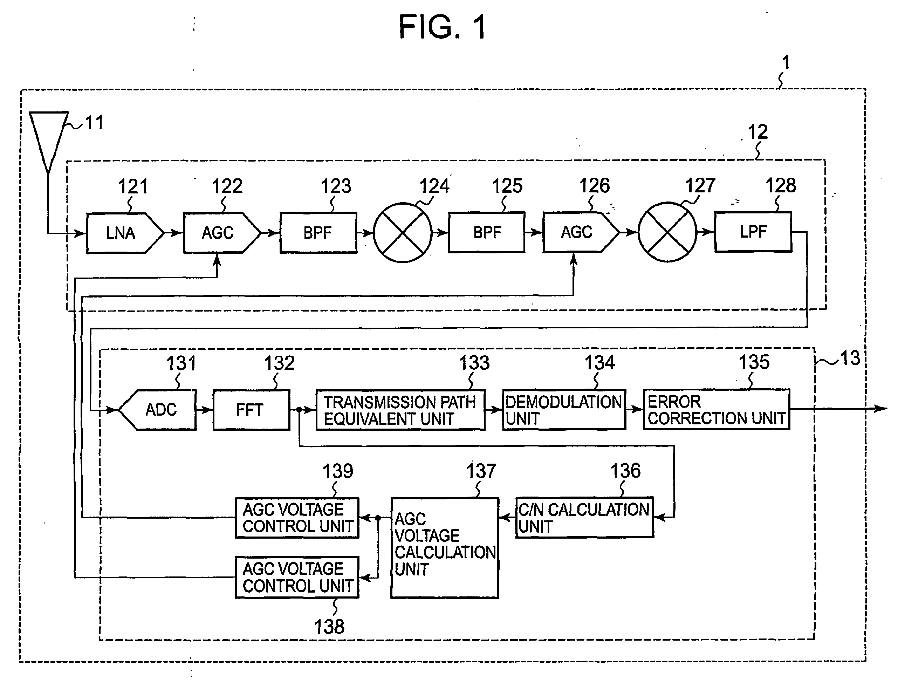

FIG. 1 is the block diagram of a terrestrial digital television broadcast reception apparatus 1. As shown in the block diagram, the terrestrial digital television broadcast reception apparatus 1 is composed of an antenna 11 which receives an electric wave, a tuner unit 12 which amplifies the received electric wave and performs the tuning to a desired broadcast wave frequency, a demodulator circuit unit 13 which mainly performs processing such as digital demodulation and an error correction and outputs a transport stream (TS), and the like.

Furthermore, the tuner unit 12 is composed of a low noise amplifier (LNA) 121, AGC' s 122 and 126, band pass filters (BPF's) 123 and 125, an RF mixer 124, an IF mixer 127 and a low pass filter (LPF) 128.

An electric wave received by the antenna 11 is first amplified by the LNA 121 and the AGC 122 by a predetermined amplification degree. The amplification degree of the AGC 122 is made to an appropriate value here by being recursively controlled by a control signal from an AGC voltage control unit 138 according to an output signal level from the BPF 123 and the like.

Only the frequency band having a predetermined width of a signal outputted from the AGC 122 is cut out by the BPF 123, and is converted to an intermediate frequency signal which has a predetermined center frequency by the RF mixer 124 further. Only the frequency band of a predetermined width of the signal outputted from the RF mixer 124 is cut out by the BPF 125, and is amplified by the AGC 126.

Then, the signal outputted from the AGC 126 is converted into a broadcast wave signal having a predetermined center frequency by passing the IF mixer 127 and the LPF 128. The amplification degree of the AGC 126 is recursively controlled to an appropriate value by a control signal from the demodulator circuit 13, which will be described later, according to an output signal level of an ADC 131 and the like.

The demodulator circuit unit 13 is composed of the ADC 131, an FFT 132, a transmission path equivalent unit 133, a demodulation unit 134, an error correction unit 135, a C/N calculation unit 136, an AGC voltage calculation unit 137 and AGC voltage control units 138 and 139.

The signal outputted from the tuner unit 12 is converted into a digital signal from an analog signal by the ADC 131, and the Fourier transformation processing of the digitized signal is performed by the FFT 132. The waveform equivalence (amplitude equivalence and phase equivalence) processing of the signal outputted from the FFT 132 is performed by the transmission path equivalent unit 133, and furthermore the demodulation processing of the processed signal is performed by the demodulation unit 134. The error correction processing is performed to the signal outputted from the demodulation unit 134 by the error correction unit 135, and the processed signal is outputted to the outside of the terrestrial digital television broadcast reception apparatus 1.

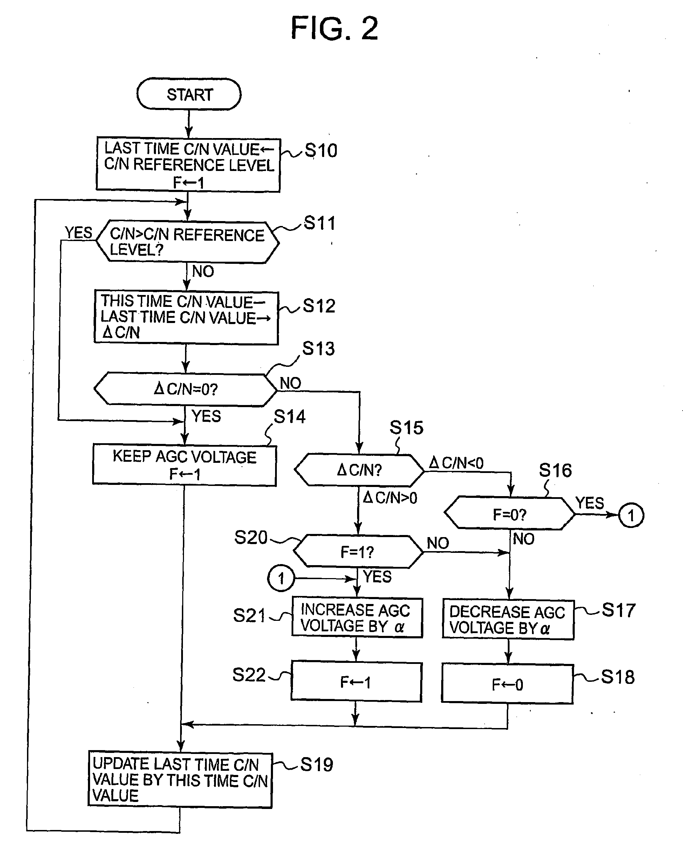

Furthermore, the signal outputted from the FFT 132 is inputted into the C/N calculation unit 136, and the C/N value thereof is calculated as a reception grade of the signal. The AGC voltage calculation unit 137 is a circuit unit of obtaining a change of the C/N value from the C/N value calculated in the C/N calculation unit 136 at this time (hereinafter referred to as a "this time C/N value") and the C/N value calculated at the last time (hereinafter referred to as a "last time C/N value"), and of determining an increase or decrease value of AGC voltages to the AGC' s 122 and 126 based on the change. The AGC voltage calculation unit 137 is composed of a microcomputer, a digital signal processor (DSP) or the like which realizes the circuit operations shown in FIG. 2. The determined increase or decrease value of the AGC voltage is inputted into the AGC voltage control units 138 and 139, and the AGC voltages are determined. Then, the AGC voltage control unit 138 outputs a control signal for controlling the AGC voltage of the AGC 122, and the AGC voltage control unit 139 outputs a control signal for controlling the AGC voltage of the AGC 126.

An example of the control of the AGC' s 122 and 126 by the AGC voltage control units 138 and 139, respectively, is described in detail. Although not shown in FIG. 1, the level (effective value) of an output signal from any of the AGC 122, the BPF 123 and the RF mixer 124 is monitored. Then, the AGC' s 122 and 126 are configured to perform the following operations. That is, when the monitored value is a predetermined level or less, only the output level of the AGC 122 is controlled by the control signal from the AGC voltage control unit 138. When the level of the output signal of the AGC 122 exceeds the predetermined level after that, only the output level of the AGC 126 is controlled in turn by the control signal from the AGC voltage control unit 139.

The AGC voltage control of the present embodiment is described in detail. FIG. 2 is a flowchart for illustrating the flow of the circuit operation of the AGC voltage calculation unit 137. First, a C/N reference value is stored in a memory (not shown) provided in the AGC voltage calculation unit 137 as a last time C/N value in advance, and a flag F indicating which processing of an increase or a decrease of the AGC voltage is performed is set to "1" (Step S10). Hereupon, the C/N reference level indicates a limit value of the C/N value desired to be maintained. The C/N reference level may be a value set beforehand, or may be suitably changed according to the level of the C/N reference level desired to be secured. Moreover, "F = 0" indicates that the processing of decreasing the AGC voltage has been performed, and "F = 1" indicates that the processing of increasing the AGC voltage has been performed.

Next, when a C/N value has been calculated and outputted by the C/N calculation unit 136, the AGC voltage calculation unit 137 discriminates whether the this time C/N value is larger than the C/N reference level or not (Step S11). When the reception sensitivity is good and the this time C/N value is larger than the C/N reference level (Step S11; Yes), the AGC voltage calculation unit 137 outputs an instruction signal instructing to make the increase or decrease of the AGC voltage 0, namely to keep the AGC voltage as it is, and sets the flag F to "1" (Step S14). On the other hand, when the reception sensitivity is bad and the this time C/N value is the C/N reference level or less (Step S11; No), the AGC voltage calculation unit 137 subtracts the last time C/N value from the this time C/N value to calculate a changed value ΔC/N of the this time C/N value from the last time C/N value (Step S12).

Then, the AGC voltage calculation unit 137 discriminates whether the changed value ΔC/N is 0 or not (Step S13). When the this time C/N value and the last time C/N value are equal to each other and the changed value ΔC/N is 0 (Step S13; Yes), the AGC voltage calculation unit 137 outputs the instruction signal instructing to make the increase or decrease of the AGC voltage 0, namely to keep the AGC voltage as it is (Step S14).

On the other hand, when the C/N value becomes less than the C/N reference value first, the this time C/N value differs from the last time C/N value, and the changed value $\Delta$C/N becomes not 0 (Step S13; No) but a negative number (Step S15; $\Delta$C/N < 0). Then, the processing moves to Step S16. The content of the flag F is judged at Step S16. Because the content in this case is "1", the processing moves to Step S17, and the AGC voltage calculation unit 137 outputs an instruction signal instructing to decrease the AGC voltage by a predetermined value $\alpha$. Then, the AGC voltage calculation unit 137 sets the flag F to "0", which indicates that the instruction signal instructing to decrease the AGC voltage has been outputted (Step 18). Then, the AGC voltage calculation unit 137 updates the last time C/N value by the this time C/N value (Step S19), and repeats the processing operation from Step S11 after this. If the C/N value is improved by having performed the operation of decreasing the AGC voltage, then the changed value $\Delta$C/N becomes a positive valueat Step S15 (Step S15; $\Delta$C/N > 0), and the processing proceeds to Step S20 to discriminate whether the flag F is "1" or not, namely to discriminate whether the instruction signal instructing to increase the AGC voltage by the predetermined value $\alpha$ has been outputted or not at the last process. In case of this time, the discrimination result is No, and then the processing proceeds to Step S17. Thus, the processing of decreasing the AGC voltage by the predetermined value $\alpha$ is preformed again.

On the other hand, if the C/N value becomes worse by having performed the operation of decreasing the AGC voltage conversely, at Step S15, the changed value $\Delta$C/N becomes a negative value (Step S15; $\Delta$C/N < 0), and the processing proceeds to Step S16 to discriminate whether the flag F is "0" or not, namely whether the instruction signal instructing to decrease the AGC voltage by the predetermined value $\alpha$ has been outputted at the last processing or not. Since the flag F is "0" at this time, the progressing proceeds to Step S21, and the AGC voltage calculation unit 137 outputs the instruction signal instructing to increase the AGC voltage by the predetermined value $\alpha$. After that, the AGC voltage calculation unit 137 sets the flag F to "1", which indicates that the AGC voltage calculation unit 137 has outputted the instruction signal instructing to increase the AGC voltage

(Step S22), and the processing proceeds to Step S19 after that.

As described above, when the C/N value is below the predetermined value, first the AGC voltage is lowered, and the changed state of the C/N value is examined. When the state of the C/N value is improved, the AGC voltage is lowered similarly to the last time. When the state of the C/N value becomes worse, the AGC voltage is raised conversely. In such a way, the control processing of the AGC voltage at the last time is considered while the AGC voltage is controlled at this time. Thereby, even when the C/N value has changed, the AGC voltage can be suitably modified, and high C/N values can be always secured.

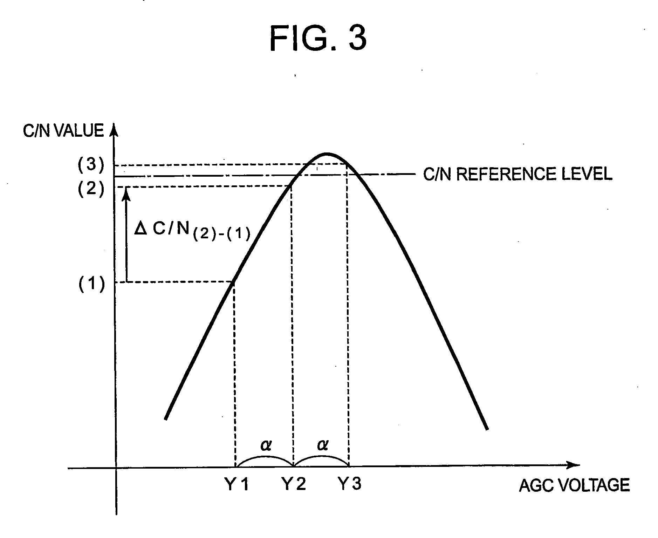

The transition of the C/N value when the AGC voltage is controlled as described above is described using FIG. 3. FIG. 3 is a graph which shows an example of the "AGC voltage-C/N value characteristic." It is supposed that the last time C/N value when the AGC voltage is Y1 [V] is C/N (1), and that the this time C/N value when the AGC voltage is Y2 [V], which has increased from the AGC voltage Y1 [V] by $\alpha$, is C/N (2). The changed value from the C/N (2) to the C/N (1) is $\Delta$C/N(2)-(1). In this case, because C/N(1) is smaller than the C/N reference level (Step S11; No), and further because $\Delta$C/N(2)-(1) is not 0 (Step S13; No) but a positive number (Step S15; $\Delta$C/N > 0), the C/N is judged to be improved by the increase of the AGC voltage at the last time, and the AGC voltage is further increased by $\alpha$ (Step S21). That is, the AGC voltage becomes Y3 [V] increased from the Y2 [V] by $\alpha$. Then, the last time C/N value is updated with the C/N (2) (Step S19).

Successively, because the AGC voltage is Y3 [V], the C/N value is calculated to be C/N (3) by the C/N calculation unit 136. When the C/N (3) is supposed to be larger than the C/N reference level (Step S11; Yes), the AGC voltage is maintained to be Y3 [V] (Step S14).

Hereupon, in the AGC voltage-C/N value characteristic shown in FIG. 3, the C/N (3) is the optimum value near the best C/N value in the whole AGC voltage. Because the AGC voltage is controlled in order that the C/N value is always the optimum value in such a way, a high C/N value is always securable. Thereby, the signal outputted from the tuner unit 12 becomes a stable signal with little noises, and consequently demodulation processing is performed accurately. Then, a stable signal is outputted from the terrestrial digital television reception apparatus 1. Therefore, the circuit performance and the reliability of the terrestrial digital television reception apparatus 1 can be improved.

[Second Embodiment]

With regard to the first embodiment, the terrestrial digital television broadcast reception apparatus 1 in which the AGC voltage calculation unit 137 outputs the same instruction signals to the AGC voltage control units 138 and 139 has been described. With regard to the second embodiment, a terrestrial digital television broadcast reception apparatus 2 in which the AGC voltage calculation unit outputs an instruction signal to each of a plurality of AGC voltage control units to control them separately is described.

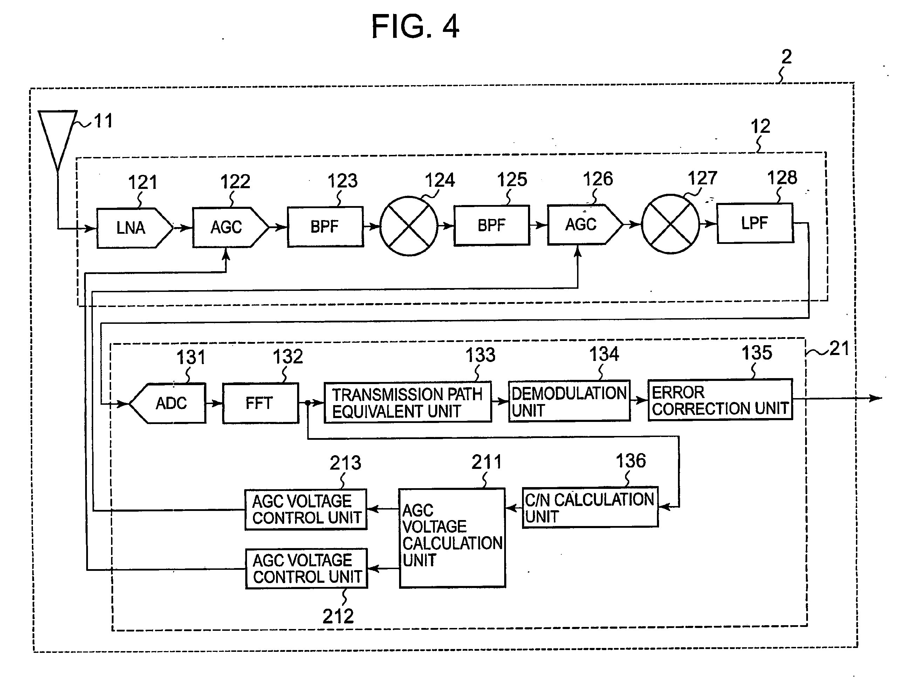

FIG. 4 is a block diagram of the terrestrial digital television broadcast reception apparatus 2. The terrestrial digital television broadcast reception apparatus 2 is configured to be provided with the antenna 11, the tuner unit 12 and the demodulator circuit unit 21. The tuner unit 12 is a circuit unit which performs the processing such as the amplification and the conversion to an intermediate frequency signal to the electric wave received by the antenna 11, and is the same circuit unit as that of the first embodiment.

The demodulator circuit unit 21 is composed of the ADC 131, the FFT 132, the transmission path equivalent unit 133, the demodulation unit 134, the error correction unit 135, the C/N calculation unit 136, an AGC voltage calculation unit 211 and AGC voltage control units 212 and 213.

A signal outputted from the tuner unit 12 is converted into a digital signal from an analog signal by the ADC 131, and the Fourier transformation processing thereof is performed by the FFT 132. The signal outputted from the FFT 132 receives waveform equivalence (amplitude equivalence and phase equivalence) processing by the transmission path equivalent unit 133, and further receives demodulation processing by the demodulation unit 134. The signal outputted from the demodulation unit 134 receives error correction processing by the error correction unit 135, and is outputted to the outside of the terrestrial digital television broadcast reception apparatus 2.

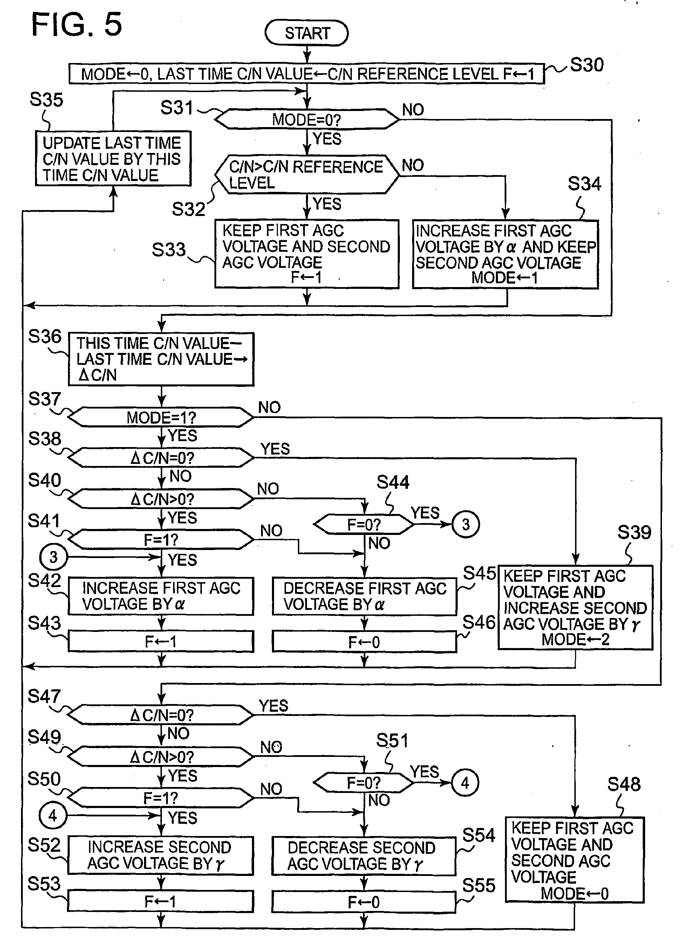

Furthermore, the signal outputted from the FFT 132 is inputted into the C/N calculation unit 136, and a C/N value is calculated as the reception grade of the signal. Then, the AGC voltage calculation unit 211 is a circuit unit obtaining a changed value from the C/N value calculates at the last time (the last time C/N value) to the C/N value calculated at this time (the this time C/N value) to determine increase or decrease values of a first AGC voltage and a second AGC voltage based on the changed value, and is composed of a microcomputer, a DSP or the like realizing the circuit operation shown in FIG. 5. Hereupon, the first AGC voltage is a voltage for performing the amplification degree control of the AGC 122, and the second AGC voltage is a voltage for performing the amplification degree control of the AGC 126.

The increase or decrease value of the first AGC voltage determined by the AGC voltage calculation unit 211 is inputted into the AGC voltage control unit 212, and the first AGC voltage is determined therein. The increase or decrease value of the second AGC voltage is inputted into the AGC voltage control unit 213, and the second AGC voltage is determined therein. Then, the AGC voltage control unit 212 outputs a control signal for controlling the first AGC voltage of the AGC 122, and the AGC voltage control unit 213 outputs a control signal for controlling the second AGC voltage of the AGC 126.

The AGC voltage control of the present embodiment is described more minutely. FIG. 5 is a flowchart for illustrating the flow of the circuit operation of the AGC voltage calculation unit 211. It is supposed that the AGC voltage control is performed in a different way to every mode. First, as the initial values, the followings are set: the variable mode is "0", the last time C/N value is the C/N reference level, and the flag F indicating the direction of increase or decrease of the last time AGC voltage is "1" (Step S30). Then, the AGC voltage calculation unit 211 discriminates whether the variable mode is "0" or not. When the variable mode is "0" (Step S31; Yes), the AGC voltage calculation unit 211 discriminates whether the this time C/N value is larger than the C/N reference level or not (Step S32). The C/N reference level is a limit value of the C/N value desired to be maintained. The C/N reference level may be a previously set value, or may be suitably changed according to the level of a C/N value desired to be secured.

When the reception sensitivity is good and the this time C/N value is larger than the C/N reference level (Step S32; Yes), the AGC voltage calculation unit 211 outputs an instruction signal instructing the increases or the decreases of the first and the second AGC voltages are 0, namely instructing to keep the first and the second AGC voltages as they are, to each of the AGC voltage control units 212 and 213, and sets the flag F to "1" (Step S33). On the other hand, when the reception sensitivity is bad and the this time C/N value is the C/N reference level or less (Step S32; No), the AGC voltage calculation unit 211 outputs an instruction signal instructing to increase the first AGC voltage by the predetermined value a to the AGC voltage control unit 212, and outputs an instruction signal instructing to keep the second AGC voltage as it is to the AGC voltage control unit 213. Then, the AGC voltage calculation unit 211 sets the variable mode to "1" (Step S34). Successively, the AGC voltage calculation unit 211 updates the last time C/N value by the this time C/N value (Step S35), and repeats the processing from Step S31. The last time C/N value is stored in the memory (not shown) provided in the AGC voltage calculation unit 211.

On the other hand, when the variable mode is not "0" (Step S31; No), the AGC voltage calculation unit 211 calculates a changed value $\Delta$C/N from the C/N value (this time C/N value) outputted from the C/N calculation unit 136 and the C/N value (last time C/N value) outputted last time (Step S36). When the variable mode is "1" (Step S37; Yes), the AGC voltage calculation unit 211 discriminates whether the changed value $\Delta$C/N is 0 or not (Step S38). When the changed value $\Delta$C/N is 0 (Step S38; Yes), the AGC voltage calculation unit 211 outputs an instruction signal instructing to keep the first AGC voltage as it is to the AGC voltage control unit 212, and outputs an instruction signal instructing to increase the second AGC voltage by a predetermined value $\gamma$ to the AGC voltage control unit 213. Then, the AGC voltage calculating unit 211 sets the variable mode to "2" (Step S39).

On the other hand, when the changed value AC/N is not 0 (Step S38; No) and the changed value $\Delta$C/N is a positive number, namely when the C/N is improved (Step S40; Yes), the AGC voltage calculation unit 211 examines the value of the flag F (Step S41). When the flag F is "1", the AGC voltage calculation unit 211 outputs the instruction signal instructing to increase the first AGC voltage by the predetermined value $\alpha$ to the AGC voltage control unit 212 similarly in the last time, and sets the flag F to "1" (Steps S42 and S43). Moreover, when the flag F is "0", the AGC voltage calculation unit 211 outputs an instruction signal instructing to decrease the first AGC voltage by the predetermined value $\alpha$ to the AGC voltage control unit 212 similarly in the last time, and sets the flag F to "0" (Steps S45 and S46). On the other hand, when the changed value $\Delta$C/N is a negative value, namely when the C/N becomes worse (Step S40; No), the AGC voltage calculation unit 211 examines the value of the flag F (Step S44). When the flag F is "0", the AGC voltage calculation unit 211 outputs the instruction signal instructing to increase the first AGC voltage by the predetermined value $\alpha$ to the AGC voltage control unit 212 contrary to the last time, and sets the flag F to "1" (Step S42 and S43). Moreover, when the flag F is not "0", the AGC voltage calculation unit 211 outputs the instruction signal instructing to decrease the first AGC voltage by the predetermined value $\alpha$ to the AGC voltage control unit 212 also contrary to the last time, and sets the flag F to "0" (Steps S45 and S46). Then, the AGC voltage calculation unit 211 repeats the circuit operation from Step S35.

When the variable mode is "2" (Step 37; No), the AGC voltage calculation unit 211 discriminates whether the changed value $\Delta$C/N is 0 or not (Step S47). Then, when the changed value $\Delta$C/N is 0 (Step S47; Yes), the AGC voltage calculation unit 211 outputs an instruction signal instructing to keep the first and the second AGC voltages as they are to each of the AGC voltage control units 212 and 213. Then, the AGC voltage calculation unit 211 sets the variable mode to "0" (Step S48).

On the other hand, when the changed value $\Delta$C/N is not "0" (Step S47; No) and the change value $\Delta$C/N is a positive value, namely when the C/N is improved (Step S49; Yes), the AGC voltage calculation unit 211 examines the value of the flag F (Step S50). When the flag F is "1", the AGC voltage calculation unit 211 outputs an instruction signal instructing to increase the second AGC voltage by the predetermined value $\gamma$ to the AGC voltage control unit 213 similarly in the last time, and sets the flag F to "1" (Steps S52 and S53). Moreover, when the flag F is "0", the AGC voltage calculation unit 211 outputs an instruction signal instructing to decrease the second AGC voltage by the predetermined value $\gamma$ to the AGC voltage control unit 213 similarly in the last time, and sets the flag F to "0" (Steps S54 and S55). On the other hand, when the changed value $\Delta$C/N is a negative number, namely the C/N becomes worse (Step S49; No), the AGC voltage calculation unit 211 examines the value of the flag F (Step S51). When the flag F is "0", the AGC voltage calculation unit 211 outputs the instruction signal instructing to increase the second AGC voltage by the predetermined value $\gamma$ to the AGC voltage control unit 213 contrary to the last time, and sets the flag F to "1" (Steps S52 and S53). Moreover, when the flag F is not "0", the AGC voltage calculation unit 211 outputs the instruction signal instructing to decrease the second AGC voltage by the predetermined value $\gamma$ to the AGC voltage control unit 213 also contrary to the last time, and sets the flag F to "0" (Steps S54 and S55). Then, the AGC voltage calculation unit 211 repeats the circuit operation from Step S35.

By controlling the first and the second AGC voltages according to the changed value of the C/N value and its positiveness or negativeness in such a way, even when the C/N value has changed, the AGC voltage can be modified immediately, and a high C/N value can be always secured.

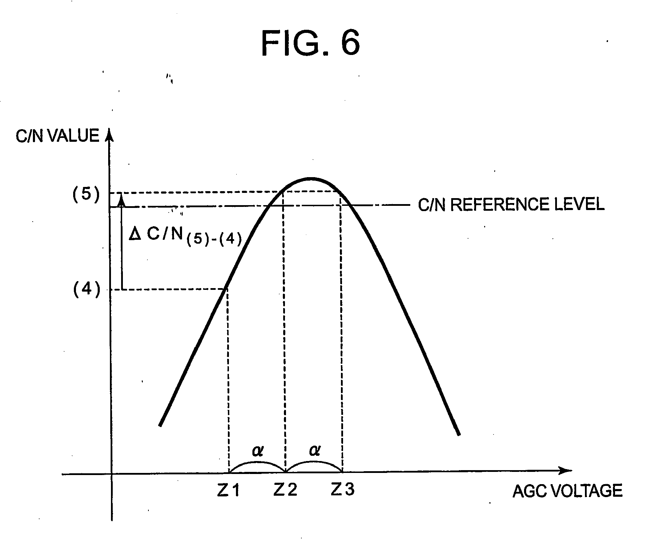

As described above, the transition of the C/N value when the first and the second AGC voltages are controlled is described using FIG. 6. FIG. 6 is a graph showing an example of "the AGC voltage-C/N value characteristic of the AGC 122." First, it is supposed that the variable mode used for the circuit operation of the AGC voltage calculation unit 211 is set to "0" and that the first AGC voltage is Z1 [V] and the C/N value is C/N (4). At this time, because the C/N (4) is smaller than the C/N reference level (Step S32; No), the first AGC voltage is increased by the predetermined value $\alpha$ to be Z2 [V]. Then, the variable mode is set to "1" (Step S34). Moreover, C/N (4) is updated as the last time C/N value (Step S35).

Next, because the first AGC voltage is Z2 [V], the C/N value is calculated by the C/N calculation unit 136 to be C/N (5). The changed value from C/N (4) to C/N (5) is $\Delta$C/N(5) - (4) (Step S36). Because the $\Delta$C/N (5) - (4) is not 0 (Step S38; No) but a positive value (Step S40; Yes), the first AGC voltage is increased by the predetermined value $\alpha$ similarly in the last processing (Step S42). That is, the first AGC voltage is increased by the predetermined value $\alpha$ from Z2 [V], and the first AGC voltage is set to Z3 [V]. Then, C/N (5) is updated as the last time C/N value (Step S35).

Successively, because the first AGC voltage is Z3 [V], the C/N value is calculated by the C/N calculation unit 136. When the calculated this time C/N value is the same value as C/N (5), namely when the changed value of the C/N value is 0 (Step S38; Yes), the first AGC voltage is maintained to Z3 [V]. Then, the second AGC voltage is increased by the predetermined value $\gamma$, and the variable mode is set to "2" (Step S39). The this time C/N value is updated as the last time C/N value (Step S35), and the second AGC voltage is adjusted in order that the C/N value may become the optimum C/N value after that (Steps S47-S55). By adjusting the second AGC voltage finely, the C/N value can be set to one near to the highest point in the characteristic shown in FIG. 6.

Here, in the "AGC voltage-C/N value characteristic curve" shown in FIG. 6, C/N (5) is the optimum value near the best C/N value in the whole AGC voltage. That is, because the first and the second AGC voltage are controlled in order that the C/N value always becomes the best value, a high C/N value is always securable. Thereby, the signal outputted from the tuner unit 12 becomes a stable signal with little noises, and consequently demodulation processing can be performed accurately. Thus, the stable signal is outputted from the terrestrial digital television reception apparatus 2. Therefore, the circuit performance and the reliability of the terrestrial digital television reception apparatus 2 can be improved.

In the second embodiment described above, although the timing switched to the processing of controlling the second AGC voltage from the processing of controlling the first AGC voltage is determined from the value of $\Delta$C/N (see processing at Steps S38 and S39 of FIG. 5), similarly in the first embodiment, it is also possible to configure the second embodiment to change the processing from that of controlling the first AGC voltage to that of controlling the second AGC voltage by monitoring the level of the output signal from any one of the AGC 122, the BPF 123 and the RF mixer 124, and by detecting whether this level is exceeded or not.

[Third Embodiment]

In the first and the second embodiments, the C/N value is used as the reception grade. In a third embodiment, a terrestrial digital television broadcast reception apparatus 3 using the errors of SP signals as reception grade is described.

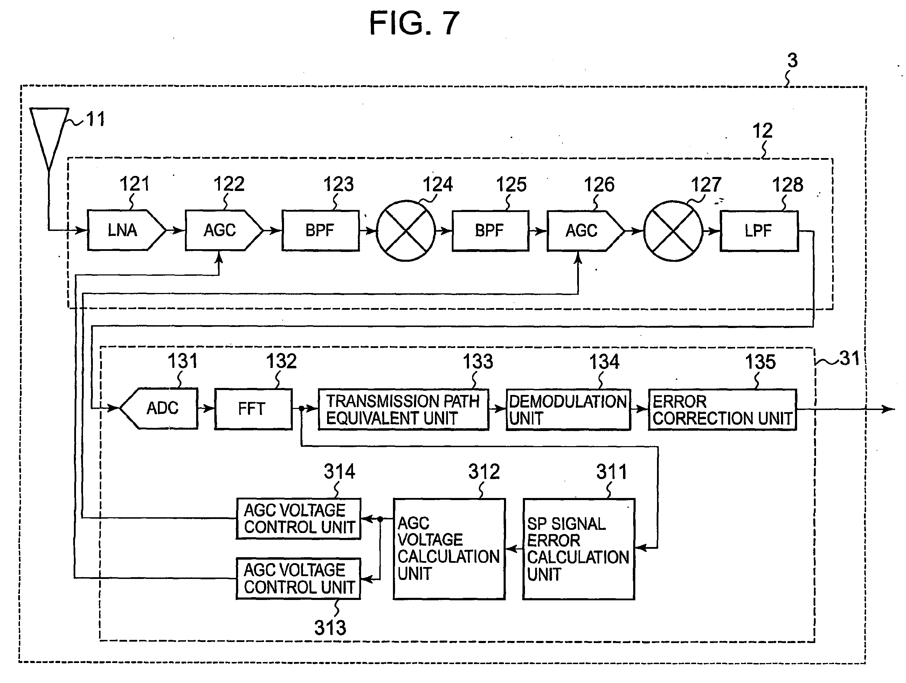

FIG. 7 is a block diagram of the terrestrial digital television broadcast reception apparatus 3. The terrestrial digital television broadcast reception apparatus 3 is configured to be provided with the antenna 11, the tuner unit 12 and a demodulator circuit unit 31. The tuner unit 12 is a circuit unit which performs processing such as an amplification and a conversion to an intermediate frequency signal to an electric wave (received signal) received by the antenna 11, and is the same circuit unit as that of the first embodiment. Moreover, the demodulator circuit unit 31 is composed of the ADC 131, the FFT 132, the transmission path equivalent unit 133, the demodulation unit 134, the error correction unit 135, an SP signal error calculation unit 311, an AGC voltage calculation unit 312 and AGC voltage control units 313 and 314.

A signal outputted from the tuner unit 12 is converted into a digital signal from an analog signal by the ADC 131, and receives Fourier transformation processing by the FFT 132. The signal outputted from the FFT 132 (frequency signal) receives waveform equivalence (amplitude equivalence and phase equivalence) processing by the transmission path equivalent unit 133, and further receives demodulation processing by the demodulation unit 134. The signal outputted from the demodulation unit 134 receives error correction processing by the error correction unit 135, and is outputted to the outside of the terrestrial digital television broadcast reception apparatus 3.

Furthermore, the signal (frequency signal) outputted from the FFT 132 is inputted into the SP signal error calculation unit 311, and "the errors of the SP signals" are calculated as the reception grade of the signal.

The calculation method of the errors of the SP signals by the SP signal error calculation unit 311 is described. The SP signals are a kind of the synchronization signal standardized in the transmission system of the terrestrial digital television broadcast, and are signals used for the waveform equivalence processing by the transmission path equivalent unit 133. Moreover, the SP signals are signals each of which has a predetermined phase and a predetermined amplitude and is arranged to be dispersed in the transmission signal of the terrestrial digital television broadcast.

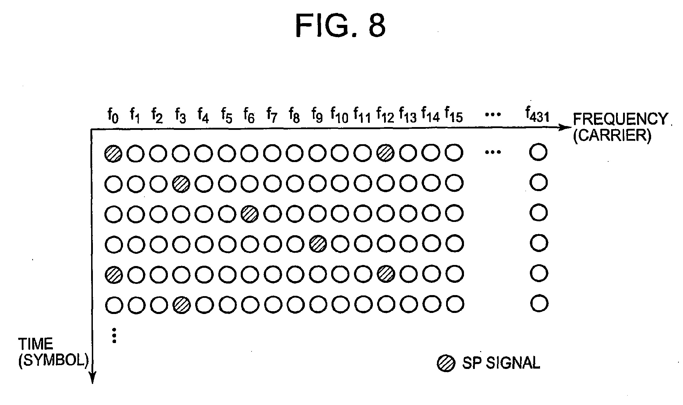

An example of the arrangement pattern of the SP signals in an OFDM symbol is shown in FIG. 8. In the figure, a black dot expresses an SP signal, and a white circle expresses a signal other than the SP signal such as a data signal. Moreover, the figure shows the case where one segment consists of 432 careers ($f_0$-$f_{431}$), and an SP signal is arranged every 12 careers. That is, 36 SP signals per one symbol are arranged.

The arrangement of the SP signals is determined to change periodically. Therefore, the arrangement positions of the SP signals are uniquely determined by specifying a symbol. In the figure, the arrangement is determined so that four kinds of arrangement patterns may appear in order.

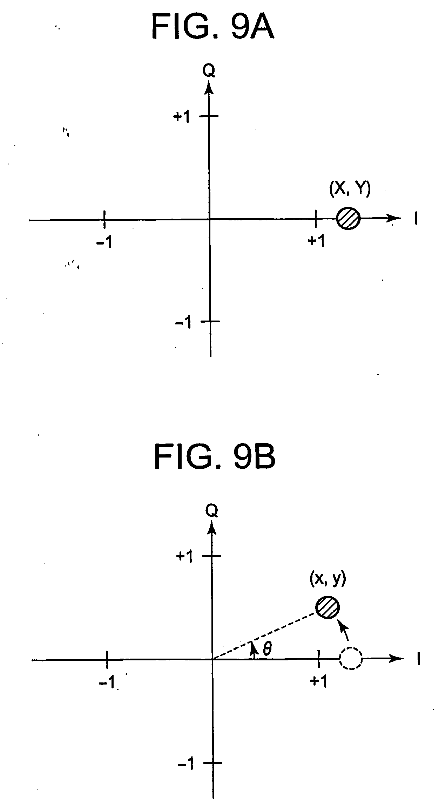

Moreover, the phase and the amplitude of an SP signal change according to the states of a transmission'way or the like as the constellation shown in FIGS. 9A and 9B. Figure 9A shows a signal point arrangement of the original SP signal at the time of transmission (hereinafter referred to as a "reference SP signal"), and FIG. 9B shows a signal point arrangement of the SP signal at the time of reception (hereinafter referred to as a "received SP signal"). The phase of the received SP signal shown in FIG. 9B is changed by "$\theta$" from the phase of the reference SP signal shown in FIG. 9A.

The SP signal error calculation unit 311 calculates a difference between an SP signal (received SP signal) in a frequency signal inputted from the FFT 132 and the predetermined reference SP signal as an "SP signal error." To put it concretely, in FIGS. 9A and 9B, when the position of the reference SP signal is set to (X, Y) and the position of the received SP signal is set to (x, y), the ratio of the electric power of noises to the carrier power about one SP signal is given by the following formula (1).

[ Formula 1]

$$\frac{(x-X)^2+(y-Y)^2}{X^2+Y^2} \qquad \cdots(1)$$

Then, as shown in the following formula (2), the average of the power ratio about each SP signal in one symbol is calculated as an "SP signal error."

[ Formula 2]

$$\frac{1}{N}\sum_{i=1}^{N}\left\{\frac{(x_i-X_i)^2+(y_i-Y_i)^2}{X_i^2+Y_i^2}\right\} \qquad \cdots(2)$$

Incidentally, in the upper formula (2), "N" shows the number of SP signals in one symbol (the number of SP signals).

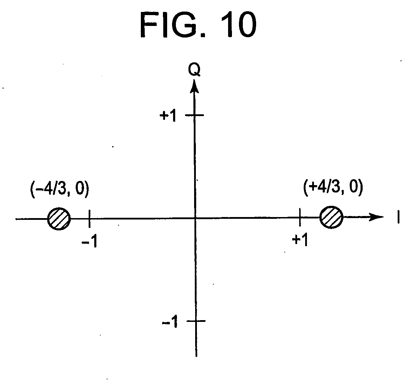

By the way, it is supposed that a binary phase shift keying (BPSK) system is used as the modulation system in the present embodiment. In the case of the BPSK system, as shown in FIG. 10, the positions of the reference SP signal become two kinds of (+4/3, 0) and (-4/3, 0), and their electric power values are equal. That is, in the formula (1), the electric power value of the reference SP signal equivalent to a denominator becomes a fixed value. For this reason, in the present embodiment, the average value of the difference between the each reference SP signal value and each received SP signal value per one symbol, which are given by the following formula (3) is used as the "SP signal error."

[ Formula 3]

$$\frac{1}{N}\sum_{i=1}^{N}\left\{(x_i-X_i)^2+(y_i-Y_i)^2\right\} \qquad \cdots(3)$$

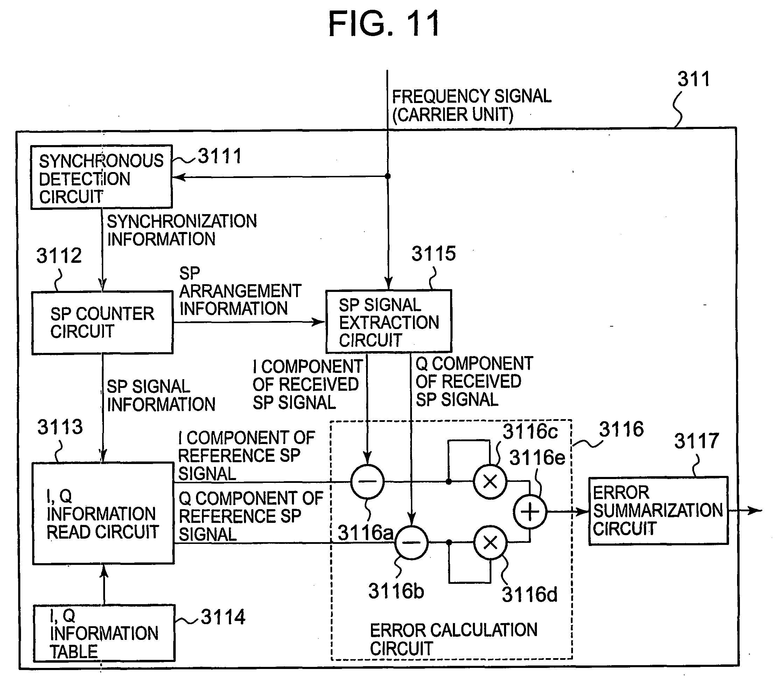

FIG. 11 shows the block diagram of the SP signal error calculation unit 311. As shown in the figure, the SP signal error calculation unit 311 is composed of a synchronous detection circuit 3111, an SP counter circuit 3112, an I, Q information read circuit 3113, an I, Q information table 3114, an SP signal extraction circuit 3115, an error calculation circuit 3116 and an error summarization circuit 3117.

The synchronous detection circuit 3111 generates and outputs synchronization information for synchronizing a received SP signal, being an SP signal in a frequency signal inputted from the FFT 132, with the reference SP signal. To put it concretely, the inputted frequency signal is monitored, and the input of the data of a new symbol is detected. Moreover, the head position of the frame which consists of a plurality of continuous symbols is detected based on the TMCC signal in the frequency signal. Then, information including the information showing that the input of a new symbol has been detected, and the information showing the detection of the head position of a frame are generated as a synchronization signal to be outputted to the SP counter circuit 3112.

The SP counter circuit 3112 generates a count value which specifies a symbol based on the synchronization information inputted from the synchronous detection circuit 3111. That is, if the count value is counted up every reception of a symbol while the frame head position is detected, the count value is updated to an initial value (for example, 0). Then, the symbol received at present is judged from the count value, and SP arrangement information specifying the arrangement pattern related to which carrier the SP signals are arranged in the symbol to be outputted to the SP signal extraction circuit 3115. For example, when the top (the uppermost in the figure) symbol is specified by the count value in FIG. 8, an arrangement pattern expressing that the SP signals are arranged in the carriers of frequencies $f_0$, $f_{12}$, $f_{24}$ ... is generated and outputted as the SP arrangement information. Moreover, SP signal information specifying which reference SP signal each SP signal expressed by the arrangement pattern is generated and is outputted to the I, Q information read circuit 3113.

I, Q information read circuit 3113 reads and outputs the I, Q component values (($X_1$, $Y_1$) to ($X_N$, $Y_N$)) of each reference SP signal specified by the SP signal information inputted from the SP counter circuit 3112 from the I, Q information table 3114.

The I, Q information table 3114 is a data table stored in a memory (not shown) provided in the SP signal error calculation unit 311, and stores the position of each reference SP signal, i.e., I, Q component values (X Y). To put it concretely, in the present embodiment, two kinds of values of (+4/3, 0) and (-4/3, 0) are stored.

The SP signal extraction circuit 3115 extracts and outputs the specified I, Q component values (($x_1$, $y_1$) to ($x_n$, $y_n$)) of each SP signal (received SP signal) among the frequency signal inputted from the FFT 132 in accordance with the arrangement pattern specified by the SP arrangement information inputted form the SP counter circuit 3112.

The error calculation circuit 3116 includes subtracters 3116a and 3116b, multipliers 3116c and 3116d, and an adder 3116e. A sum of squares of the difference between the received SP signal and the reference SP signal of each signal in each symbol is obtained for every symbol, and the obtained sum of squares is outputted as the SP signal error.

The subtracter 3116a subtracts the I component value X of the reference SP signal inputted from the I, Q information read circuit 3113 from the I component value x of the received SP signal inputted from the SP signal extraction circuit 3115, and outputs the subtraction result. The multiplier 3116c squares the value (x - X) inputted from the subtracter 3116a, and outputs the squared value.

The subtracter 3116b subtracts the Q component value Y of the reference SP signal inputted from the I, Q information read circuit 3113 from the Q component value y of the received SP signal inputted from the SP signal extraction circuit 3115, and outputs the subtraction result. The multiplier 3116d squares the value (y - Y) inputted from the subtracter 3116b, and outputs the squared value.

Then, the adder 3116e adds the value $(x - X)^2$ outputted from the multiplier 3116c and the value $(y - Y)^2$ outputted from the multiplier 3116d, and outputs the addition result.

Then, the error summarization circuit 3117 adds all of the values outputted from the error calculation circuit 3116, and divides the added value by the number N of the SP signals per symbol to calculate the SP signal error per symbol. The value outputted from the error summarization circuit 3117 is the "SP signal error" per symbol which the SP signal error calculation circuit 3116 calculates.

Then, the AGC voltage calculation unit 312 determines the AGC voltage of each of the AGC' s 122 and 126 based on the "SP signal error" calculated by the SP signal error calculation unit 311. To put it concretely, the AGC voltage calculation unit 312 obtains a changed value from the SP signal error calculated at the last time (hereinafter referred to as "the last time error") to the SP signal error calculated this time (hereinafter referred to as a "this time error"), and determines the increase or decrease value of the first and the second AGC voltages based on the obtained changed value. Here, the first AGC voltage is a voltage for performing the amplification degree control of the AGC 122, and the second AGC voltage is a voltage for performing the amplification degree adjustment of the AGC 126.

The increase or decrease value of the first AGC voltage determined by the AGC voltage calculation unit 312 is inputted into the AGC voltage control unit 313, and the first AGC voltage is determined. The increase or decrease value of the second AGC voltage is inputted into the AGC voltage control unit 314, and the second AGC voltage is determined. Then, the AGC voltage control unit 313 outputs a control signal for controlling the first AGC voltage of the AGC 122, and the AGC voltage control unit 314 outputs a control signal for controlling the second AGC voltage of the AGC 126.

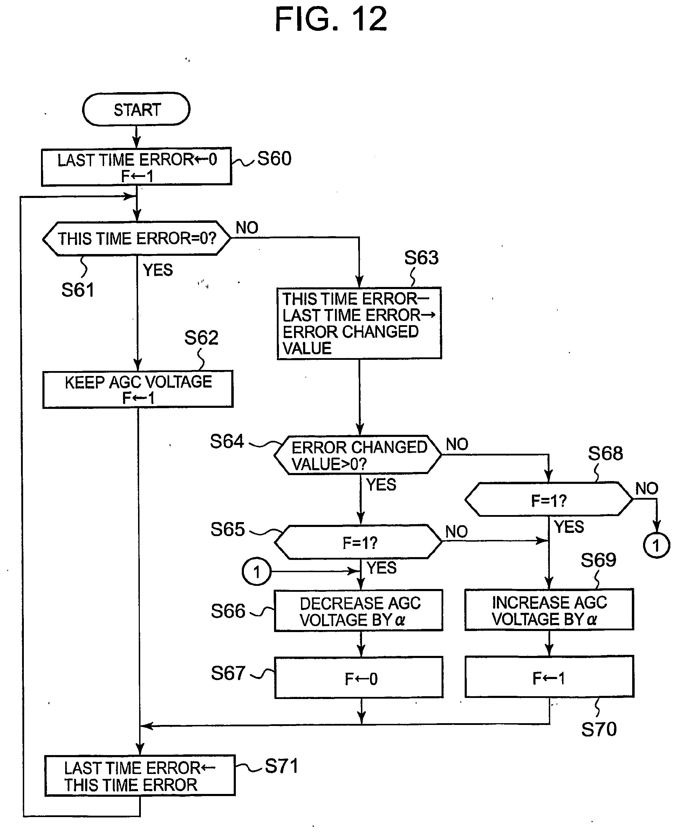

The AGC voltage control of the present embodiment is further described in detail. FIG. 12 is a flowchart for illustrating the flow of the circuit operation of the AGC voltage calculation unit 312. First, the AGC voltage calculation unit 312 stores "0" in the memory (not shown) provided in the AGC voltage calculation unit 312 as the last time error, and sets the flag F indicating having performed the processing of an increase or a decrease of the AGC voltage to "1" (Step S60).

Next, when the SP signal error is calculated by the SP signal error calculation unit 311 and the calculation result is outputted, the AGC voltage calculation unit 312 judges whether the inputted value, namely the this time error, is "0" or not. When the this time error is "0" (Step S61; Yes), the AGC voltage calculation unit 312 outputs an instruction signal instructing to set the increase or decrease of the AGC voltage to "0", namely to keep the AGC voltage as it is, and sets the flag F to "1" (Step S62).

On the other hand, when the tins time error is not "0" (Step S61; No), the AGC voltage calculation unit 312 calculates an error changed value by subtracting the last time error from the this time error (Step S63), and judges whether the error changed value is larger than "0" or not.

When the error changed value is larger than "0" (Step S64: Yes), the AGC voltage calculation unit 312 judges the value of the flag F. When the value of the flag F is "1", which indicates that an instruction signal instructing to increase the AGC voltage has been issued at the last time, the AGC voltage calculation unit 312 outputs an instruction signal instructing to decease the AGC voltage by the predetermined value $\alpha$ (Step S66). Then, the AGC voltage calculation unit 312 sets the flag F to "0", which indicates that an instruction signal instructing to decrease the AGC voltage has been issued (Step S67), and the processing proceeds to Step S71 after that.

Moreover, when the value of the flag F is not "1", namely when it is "0", which indicates that the instruction signal instructing to decrease the AGC voltage last time has been issued (Step, S65; No), the AGC voltage calculation unit 312 outputs an instruction signal to increase the AGC voltage by a predetermined value (Step S69). Then, the AGC voltage calculation unit 312 sets the flag F to "1", which indicates that the instruction signal instructing to increase the AGC voltage has been issued, and then the processing proceeds to Step S71 after that.

On the other hand, when the error changed value is not larger than "0", namely it is smaller than "0" (Step S64; No), the AGC voltage calculation unit 312 judges the value of the flag F. When the value of the flag F is "1" (Step S68; Yes), the AGC voltage calculation unit 312 outputs an instruction signal instructing to increase the AGC voltage by the predetermined $\alpha$ (Step S69), and sets the flag F to "1". The processing proceeds to Step S71 after that. On the other hand, when the flag F is not "1", namely when the flag F is "0" (Step S68; No), the AGC voltage calculation unit 312 outputs an instruction signal instructing to decrease the AGC voltage by the predetermined $\alpha$ (Step S66), and sets the flag F to "0" (Step S67). After that, the processing proceeds to Step S71.

Then, at Step S71, the AGC voltage calculation unit 312 updates the this time error as the last time error (Step S71), and the processing of the AGC voltage calculation unit 312 returns to Step S61 after that.

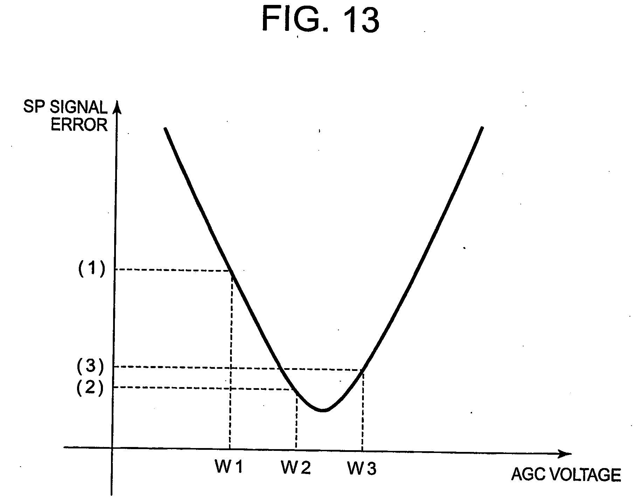

The transition of the C/N value when the AGC voltage control has been performed in the way described above is described with reference to FIG. 13. The figure is a graph showing an example of the "AGC voltage-SP signal error" characteristic. By the way, there is a relation an example of which is shown in FIG. 16 as the characteristic of the C/N value to the AGC voltage. Moreover, there is a reverse relation between the C/N value and the SP signal error to the reception grade. That is, the increase of the C/N value expresses the improvement of the reception grade, and the decrease of the C/N value expresses the degradation of the reception grade. On the other hand, the increase of the SP signal error expresses the increase of noises, namely the degradation of the reception grade, and the decrease of the SP signal error expresses the decrease of the noises, namely the improvement of the reception grade. Consequently, there is the relation between the C/N value and the SP signal: when the C/N value becomes larger, the SP signal error becomes smaller; and conversely when the C/N value decreases, the SP signal error becomes larger. For this reason, the characteristic of the SP signal error to the AGC voltage becomes the graph shown in FIG. 13, for example.

In FIG. 13, it is supposed that the SP signal error is an error (1) when the AGC voltage is W1 [V], and that the SP signal error is error (2) when the AGC voltage is W2 [V]. Then, when the AGC voltage is increased from W1 [V] to W2 [V] by $\alpha$, because the error (2), which is the this time error, is smaller than the error (1), which is the last time error, (error (2) < error (1)), the error changed value becomes a negative value (Step S64; No), and the flag F is "1", which indicates that the AGC voltage has been increased (Step S68; Yes). Consequently, it is judged that the error became smaller, namely, it is judged that the C/N value has been improved, and then the AGC voltage is further increased by $\alpha$ to be W3 [V] (Step S69). Then, the error (2) is set as the last time error (Step S71).

When the AGC voltage becomes W3 [V], the this time error is made to an error (3), and the error (3) is larger than the last time error (2) (error (3) > error (2)), the error changed value becomes a positive value (Step S64; Yes). Moreover, because the flag F is "1" (Step S65; Yes), it is judged that the error has increased, namely the C/N value has fallen, and the AGC voltage is decreased by $\alpha$ (Step S66). Then, the error (3) is set as the last time error (Step S71).

In such a way, the AGC voltage is controlled in order that the SP signal error may become the smallest, namely in order that the C/N value may become the highest (the best) value. Consequently, an always high C/N value is secured. Thereby, the signal outputted from the demodulator circuit unit 31 becomes a stable signal with little noises, and consequently the demodulation processing is performed accurately. Moreover, a stable signal is outputted from the terrestrial digital television broadcast reception apparatus 3. Therefore, the circuit performance and the reliability of the terrestrial digital television broadcast reception apparatus 3 can be improved.

In addition, in the third embodiment, although the SP signal error, which is a kind of a synchronization signal, is used as the reception grade, even if other synchronization signals such as a CP signal are used, the reception grade is realizable similarly.

Moreover, although the average value of the difference between the reference SP signal and the received SP signal is used as the "SP signal error" to all of the SP signals in one symbol, (1) in stead of all of the SP signals, some of them (for example, the careers near the center of the symbol and the careers of the latter half portion, and the like) may be used; (2) an average value about several symbols in the past including the present symbol may be used; and (3) in stead of the average value, the total of the difference about each SP signal may be used.

Moreover, as an modulation system, although the case of a BPSK system has been described, similarly other modulation systems such as a quadrature phase shift keying (QPSK) system, a 16-quadrature amplitude modulation (QAM) system and a 64-QAM system may be applicable. However, in this case, because the electric power value of each reference SP signal is not constant, the SP signal error is calculated in accordance with the formula (2).

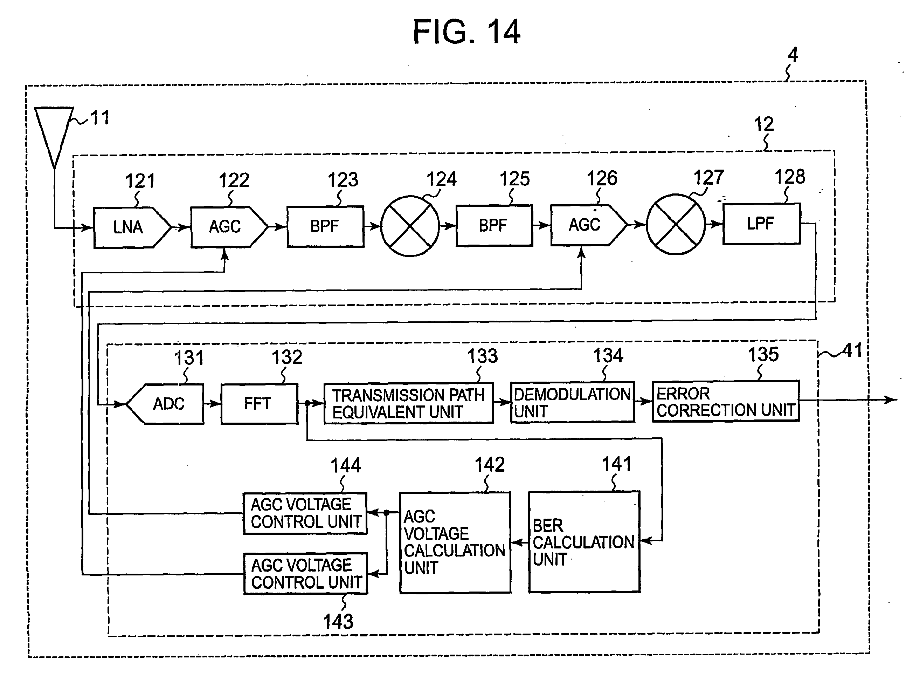

Moreover, although the C/N value is used as the reception grade in the first and the second embodiments described above and the SP signal error is used as the reception grade in the third embodiment described above, a bit error rate (BER) may be used as another reception grade. The block diagram of a terrestrial digital television broadcast reception apparatus 4 using the BER as the reception grade is shown in FIG. 14 as a modified example of the third embodiment. Incidentally, in this figure, the same reference marks are attached to the same configuration elements as those of each embodiment described above (see FIGS. 1, 4 and 7).

According to FIG. 14, a terrestrial digital television broadcast reception apparatus 4 is configured to be provided with the antenna 11, the tuner unit 12 and a demodulator circuit unit 41. The demodulator circuit unit 41 is composed of the ADC 131, the FFT 132, the transmission path equivalent unit 133, the demodulation unit 134, the error correction unit 135, a BER calculation unit 141, an AGC voltage calculation unit 142, and AGC voltage control units 143 and 144.

The BER calculation unit 141 calculates a BER as the reception grade of a signal (frequency signal) inputted from the FFT 132.

The AGC voltage calculation unit 142 determines the increase or decrease values of the first AGC voltage and the second AGC voltage based on the BER calculated by the BER calculation unit 141 similarly in the AGC voltage calculation unit 136 of the first embodiment described above. That is, the AGC voltage calculation unit 142 obtains a changed value from the BER (last time BER) calculated by the BER calculation unit 141 at the last time to the BER (this time BER) calculated at this time, and determines the increase or decrease values of the first AGC voltage and the second AGC voltage based on the changed value.

Then, the AGC voltage control unit 143 outputs a control signal for controlling the amplification degree of the first AGC voltage of the AGC 122 based on the increase or decrease value of the first AGC voltage determined by the AGC voltage calculation unit 142, and the AGC voltage control unit 144 outputs a control signal for controlling the amplification degree of the second AGC voltage of the AGC 126 based on the increase or decrease value of the second AGC voltage determined by the AGC voltage calculation unit 142.

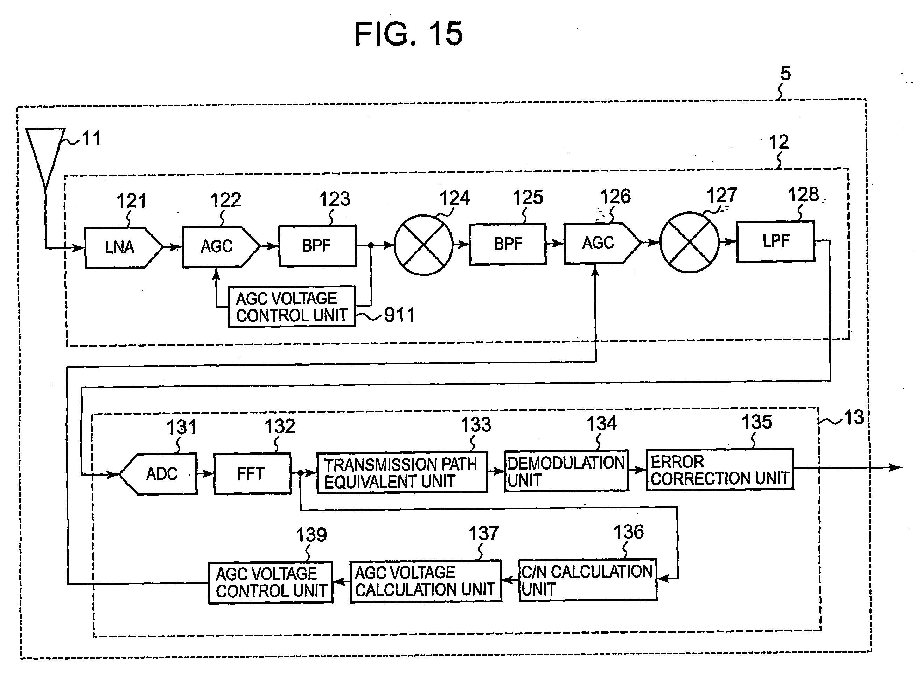

Moreover, although the AGC voltage calculation unit 137 determines the increase or decrease values of the AGC voltages to the AGC's 122 and 126 based on the change C/N value calculated by the C/N calculation unit 136 in the first embodiment described above, as shown in FIG. 15, the AGC voltage calculation unit 137 may determine the increase or decrease value of the AGC voltage to the AGC 126 on one side, and may output the determined voltage to the AGC voltage control unit 139, which outputs the control signal for controlling the AGC voltage of the AGC 126. In this case, the AGC 122 is recursively controlled by the control signal from an AGC control unit 911 according to the level of the output signal from the BPF 123 or the like. The block diagram of the terrestrial digital television broadcast reception apparatus 5 as a modified example of the first embodiment described above is shown in FIG. 15.

Furthermore, similarly as for the third embodiment, the AGC voltage calculation unit 312 is configured to determine the increase or decrease values of the AGC voltages to the AGC's 122 and 126 based on the change of the SP signal error calculated by the SP signal error calculation unit 311, but, although it is not shown, the AGC voltage calculation unit 312 may determine the increase or decrease value of the AGC voltage to the AGC 126 on one side, and may output the determined voltage to the AGC voltage control unit 314. In this case, the AGC 122 is recursively controlled by the control signal from the AGC control unit 911 according to the level of the output signal from the BPF 123 or the like.

**Claims**

1. A reception control circuit, comprising:

   a reception grade detection unit (136; 141; 311) for detecting a reception grade of a received signal received by a tuner unit (12) including an amplification unit (122, 126);
   a reference level detection unit (S11; S32) for detecting whether the reception grade detected by the reception grade detection unit satisfies a predetermined condition, said predetermined condition indicating that the reception grade is better than a predetermined reference level;
   a change detection unit (S12, S13, S19; S35, S36, S38, S47) for detecting a change of the reception grade based on the reception grade detected by the reception grade detection unit;
   and a control signal output unit (S15-S18, S20-S22; S39-S46, S48-S55) for outputting a control signal for controlling an amplification degree of the amplification unit of the tuner unit to raise or lower the amplification degree based on the change of the reception grade detected by the change detection unit,
   **characterized in that**
   said change detection unit (S12, S13, S19; S35, S36, S38, S47) is adapted to detect the change of the reception grade only when the reception grade is detected not to satisfy the predetermined condition by the reference level detection unit, and said control signal output unit (S15-S18, S20-S22; S39-S46, S48-S55) is adapted to output a control signal for controlling the amplification degree of the amplification unit to remain constant, when the reception grade is detected to satisfy the predetermined condition by the reference level detection unit.

2. The reception control circuit as claimed in claim 1, wherein the change detection unit (S12, S13, S19) includes a difference operation unit (S12) for obtaining a difference between a reception grade detected at this time and a reception grade detected at a last time; a discrimination unit (S13) for discriminating existence of the change of the reception grade by discriminating whether the obtained difference is zero or not; a storage unit (S19) for storing the reception grade detected at this time as the reception grade detected at the last time after discrimination has been performed by the discrimination unit.

3. The reception control circuit as claimed in claim 2, wherein the control signal output unit (S14) does not change the amplification degree when the discrimination unit has discriminated that there is no change of the reception grade.

4. The reception control circuit as claimed in claim 2, wherein the control signal output unit (S15-S18, S20-S22) includes a positive/negative judgment unit (S15) for judging positiveness and negativeness of the difference obtained by the difference operation unit when the discrimination unit has discriminated that there is a change of the reception grade; and an amplification degree control unit (S16-S17, S20-S22) for performing control of the amplification degree based on a judgment result of the positiveness and negativeness judgment unit and a state of the control signal outputted in detection of the change at the last time.

5. The reception control circuit as claimed in claim 4, wherein the amplification degree control unit (S16-S17, S20-S21) raises the amplification degree when the difference obtained by the difference operation unit is positive and the control signal outputted in detection of the change at the last time is in a state of permitting a rising control, and when the difference obtained by the difference operation unit is negative and the control signal outputted in detection of the change at the last time is in a state of permitting a lowering control, and lowers the amplification degree when the difference obtained by the difference operation unit is negative and the control signal outputted in detection of the change at the last time is in the state of permitting the rising control, and when the difference obtained by the difference operation unit is positive and the control signal outputted in detection of the change at the last time is in the state of permitting lowering control.

6. The reception control circuit as claimed in claim 5, wherein the amplification degree control unit (S18, S22) makes the control signal in a state of performing the rising control when the amplification degree has been raised, and makes the control signal in a state of performing the lowering control when the amplification degree has been lowered.

7. The reception control circuit as claimed in any of claims 1 to 6, wherein the reception grade detection unit (136) detects a C/N value of the received signal.

8. The reception control circuit as claimed in any of claims 1 to 6, wherein the reception grade detection unit (141) detects a BER value of the received signal.

9. A reception control circuit as claimed in any of claims 1 to 8, wherein said tuner unit (12) including a plurality of amplification units (122, 126); said reception control circuit further comprising
an amplification degree change unit (S34) for changing at least one of amplification degrees of the plurality of amplification units only when the reception grade is detected not to satisfy the predetermined condition by the reference level detection unit; wherein
said change detection unit (S35, S36, S38, S47) is adapted to detect a change of the reception grade based on a change of the amplification degree by the amplification degree change unit; and
said control signal output unit (S39-S46, S48-S55) is adapted to output a control signal for controlling an amplification degree of each of the plurality of amplification units of the tuner unit based on the change of the reception grade detected by the change detection unit.

10. The reception control circuit as claimed in claims 2 and 9, wherein the control signal output unit (S39, S48) is adapted to control the amplification degree change unit in order to change an amplification degree of another amplification unit of the tuner unit when the discrimination unit has discriminated that there is no change of the reception grade.

11. A reception control circuit as claimed in any of claims 1 to 6, wherein
said reception grade detection unit (311) is adapted to detect, as a reception grade, an error of phases and amplitudes owned by SP signals arranged in a received signal in a way of being dispersed therein, from phases and amplitudes having been previously determined, the previously determined phases and the previously determined amplitudes owned by a reference SP signal;
wherein said predetermined condition is satisfied, if the error detected by said reception grade detection unit is zero.

12. The reception control circuit as claimed in claim 11, wherein the reception grade detection unit (311) detects an average value of power ratios of noises of a predetermined number of received SP signals and the reference SP signal to carrier power as an error.

**13.** A reception control method, comprising:

a reception grade detection step of detecting a reception grade of a received signal received by a tuner unit (12) including an amplification unit (122, 126);

a reference level detection step (S11) of detecting whether the detected reception grade satisfies a predetermined condition or not, said predetermined condition indicating that the reception grade is better than a predetermined reference level;

a change detection step (S12, S13, S19) of detecting a change of the reception grade detected at the reception grade detection step; and

a control signal output step (S15-S18, S20-S22) of outputting a control signal for controlling an amplification degree of an amplification unit of the tuner unit to raise or lower the amplification degree based on the change of the detected reception grade,

**characterized in that**

said change detection step (S12, S13, S19) detecting the change of the reception grade only when the reception grade is detected not to satisfy the predetermined condition, and

said control signal output step outputting (S14) a control signal for controlling the amplification degree of the amplification unit to remain constant, when the reception grade is detected to satisfy the predetermined condition by the reference level detection step.

**14.** A reception control method as claimed in claim 13, wherein said tuner unit (12) including a plurality of amplification units (122, 126); the method further comprising

an amplification degree change step (S34) of changing at least one of amplification degrees of the plurality of amplification units only when the reception grade is detected not to satisfy the predetermined condition; wherein

said change detection step (S35, S36, S38, S47) detecting a change of the detected reception grade based on a change of the amplification degree; and

said control signal output step (S39-S46, S48-S55) outputting a control signal for controlling an amplification degree of each of the plurality of amplification units of the tuner unit based on the detected change of the reception grade.

**15.** A reception control method as claimed in claim 13 or 14, wherein

said reception grade detection step detecting, as a reception grade, an error of phases and amplitudes owned by SP signals arranged in a received signal in a way of being dispersed therein, from phases and amplitudes having been previously determined, the previously determined phases and the previously determined amplitudes owned by a reference SP signal; and

said predetermined condition is satisfied, if the error detected by said reception grade detection step is zero.

**Patentansprüche**

**1.** Empfangssteuerschaltung, umfassend:

eine Empfangsqualitätserkennungseinheit (136; 141; 311) zum Erkennen einer Empfangsqualität eines von einer Tunereinheit (12), die eine Verstärkungseinheit (122, 126) einschließt, empfangenen Signals;

eine Referenzniveauerkennungseinheit (S11, S32) zum Erkennen, ob die von der Empfangsqualitätserkennungseinheit erkannte Empfangsqualität eine vorbestimmte Bedingung erfüllt, wobei die vorbestimmte Bedingung anzeigt, dass die Empfangsqualität besser ist als ein vorbestimmtes Referenzniveau;

eine Änderungserkennungseinheit (S12, S13, S19; S35, S36, S38, S47) zum Erkennen einer Änderung der Empfangsqualität basierend auf der von der Empfangsqualitätserkennungseinheit erkannten Empfangsqualität; und eine Steuersignalausgabeeinheit (S15-S18, S20-S22, S39-S46, S48-S55) zum Ausgeben eines Steuersignals zum Steuern eines Verstärkungsgrades der Verstärkungseinheit des Tuners, um den Verstärkungsgrad basierend auf der von der Änderungserkennungseinheit erkannten Änderung der Empfangsqualität anzuheben oder zu verringern,

**dadurch gekennzeichnet, dass**

die Änderungserkennungseinheit (S12, S13, S19; S35, S36, S38, S47) angepasst ist, die Änderung der Empfangsqualität nur zu erkennen, wenn die Referenzniveauerkennungseinheit erkennt, dass die Empfangsqualität die vorbestimmte Bedingung nicht erfüllt, und

die Steuersignalausgabeeinheit (S15-S18, S20-S22; S39-S46, S48-S55) angepasst ist, ein Steuersignal zum Steuern des Verstärkungsgrades der Verstärkungseinheit so, dass er konstant bleibt, auszugeben, wenn die Referenzniveauerkennungseinheit erkennt, dass die Empfangsqualität die vorbestimmte Bedingung erfüllt.

**2.** Steuerschaltung nach Anspruch 1, wobei die Änderungserkennungseinheit (S12, S13, S19) eine Differenzoperationseinheit (S12) zum Erhalten einer Differenz zwischen einer zu einem aktuellen Zeitpunkt erkannten Empfangsqualität und einer zu einem letzten Zeitpunkt erkannten Empfangsqualität; eine Unterscheidungseinheit (S13) zum Erfassen der Existenz der Änderung der Empfangsqualität durch Unterscheiden, ob die erhaltene Differenz Null ist oder nicht; eine Speichereinheit (S19) zum Speichern der zu dem aktuellen Zeitpunkt erkannten Empfangsqualität als der zu dem letzten Zeitpunkt erkannten Empfangsqualität, nachdem die Unterscheidung von der Unterscheidungseinheit ausgeführt wurde, enthält.

**3.** Empfangssteuerschaltung nach Anspruch 2, wobei die Steuersignalausgabeeinheit (S14) den Verstärkungsgrad nicht ändert, wenn die Unterscheidungseinheit erfasst hat, dass sich die Empfangsqualität nicht geändert hat.

**4.** Empfangssteuerschaltung nach Anspruch 2, wobei die Steuersignalausgabeeinheit (S15-S18, S20-S22) eine Positiv-Negativ-Beurteilungseinheit (S15) zum Beuteilen, ob die von der Differenzoperationseinheit erhaltene Differenz positiv oder negativ ist, wenn die Unterscheidungseinheit erfasst hat, dass es eine Änderung der Empfangsqualität gibt; und eine Verstärkungsgradsteuereinheit (S16-S17, S20-S22) zum Ausführen einer Steuerung des Verstärkungsgrades basierend auf einem Beurteilungsergebnis der Positiv/Negativ-Beurteilungseinheit und einem Zustand des beim Erkennen der Änderung zu dem letzten Zeitpunkt ausgegebenen Steuersignals, enthält.

**5.** Empfangssteuerschaltung nach Anspruch 4, wobei die Verstärkungsgradsteuereinheit (S16-S17, S20-S21) den Verstärkungsgrad anhebt, wenn die von der Differenzoperationseinheit erhaltene Differenz positiv ist und dass beim Erkennen der Änderung zu dem letzten Zeitpunkt ausgegebene Signal in einem Zustand ist, dass eine Steuerung zum Anheben erlaubt ist und wenn die von der Differenzoperationseinheit erhaltene Differenz negativ ist und das beim Erkennen der Änderung zu dem letzten Zeitpunkt ausgegebene Signal in einem Zustand ist, dass eine Steuerung zum Verringern erlaubt ist, und den Verstärkungsgrad verringert, wenn die von der Differenzoperationseinheit erhaltene Differenz negativ ist und das beim Erkennen der Änderung zu dem letzten Zeitpunkt ausgegebene Signal in dem Zustand ist, dass eine Steuerung zum Anheben erlaubt ist, und wenn die von der Differenzoperationseinheit erhaltene Differenz positiv ist und das beim Erkennen der Änderung zu dem letzten Zeitpunkt ausgegebene Signal in dem Zustand ist, dass eine Steuerung zum Verringern erlaubt ist.

**6.** Empfängerschaltung nach Anspruch 5, wobei die Verstärkungsgradsteuereinheit (S18, S22) das Steuersignal in einen Zustand des Ausführens der Steuerung zum Anheben versetzt, wenn der Verstärkungsgrad angehoben wurde, und das Steuersignal in einen Zustand des Ausführens der Steuerung zur Verringerung versetzt, wenn der Verstärkungsgrad verringert wurde.

**7.** Empfangssteuerschaltung nach einem der Ansprüche 1 bis 6, wobei die Empfangsqualitätserkennungseinheit (136) einen Wert des Träger-Rausch-Verhältnisses (original: C/N value) des empfangenen Signals erkennt.

**8.** Empfangssteuerschaltung nach einem der Ansprüche 1 bis 6, wobei die Empfangsqualitätserkennungseinheit (141) einen Wert der Bitfehlerrate (original: BER value) des empfangenen Signals erkennt.

**9.** Empfangssteuerschaltung nach einem der Ansprüche 1 bis 8, wobei die Tunereinheit (12) eine Mehrzahl von Verstärkungseinheiten (122, 126) enthält, und die Empfangssteuerschaltung weiterhin umfasst:

eine Verstärkungsgradänderungseinheit (S34) zum Ändern wenigstens eines Verstärkungsgrades der Mehrzahl von Verstärkungseinheiten nur, wenn die Referenzniveauerkennungseinheit erkennt, dass die Empfangsqualität die vorbestimmte Bedingung nicht erfüllt, wobei
die Änderungserkennungseinheit (S35, S36, S38, S47) angepasst ist, eine Änderung der Empfangsqualität basierend auf einer Änderung des Verstärkungsgrades durch die Verstärkungsgradänderungseinheit zu erkennen;
die Steuersignalausgabeeinheit (S39-S46, S48-S55) angepasst ist, ein Steuersignal zum Steuern eines Verstärkungsgerades eines jeden der Mehrzahl von Verstärkungseinheiten der Tunereinheit basierend auf der von der Änderungserkennungseinheit erkannten Änderung der Empfangsqualität auszugeben.

**10.** Empfangssteuerschaltung nach den Ansprüchen 2 und 9, wobei die Steuersignalausgabeeinheit (S39, S48) angepasst ist, die Verstärkungsgradänderungseinheit so zu steuern, dass sie einen Verstärkungsgrad einer anderen Verstärkungseinheit der Tunereinheit ändert, wenn die Unterscheidungseinheit erfasst hat, dass sich die Empfangsqualität nicht geändert hat.

**11.** Empfangssteuereinheit nach einem der Ansprüche 1 bis 6, wobei

die Empfangsqualitätserkennungseinheit (311) angepasst ist, als eine Empfangsqualität einen Fehler von Phasen und Amplituden von in einem empfangenen Signal verstreut angeordneten SP-Signalen gegenüber früher bestimmten Phasen und Amplituden zu erkennen, wobei die früher bestimmten Phasen und die früher bestimmten Amplituden zu einem Referenz-SP-Signal gehören;

wobei die vorbestimmte Bedingung erfüllt ist, wenn der von der Empfangsqualitätserkennungseinheit erkannte Fehler Null ist.

**12.** Empfangssteuerschaltung nach Anspruch 11, wobei die Empfangsqualitätserkennungseinheit (311) einen Durchschnittswert von Leistungsverhältnissen des Rauschens einer vorbestimmten Anzahl von empfangenen SP-Signalen und dem Referenz-SP-Signal zur Trägerleistung als einen Fehler erkennt.

**13.** Empfangssteuerverfahren, umfassend:

einen Empfangsqualitätserkennungsschritt des Erkennens einer Empfangsqualität eines von einer Tunereinheit (12), die eine Verstärkungseinheit (122, 126) einschießt, empfangenen Signals;

einen Referenzniveauerkennungsschritt (S11) des Erkennens, ob die erkannte Empfangsqualität eine vorbestimmte Bedingung erfüllt, wobei die vorbestimmte Bedingung anzeigt, dass die Empfangsqualität besser ist, als ein vorbestimmtes Referenzniveau;

einen Änderungserkennungsschritt (S12, S13, S19) des Erkennens einer Änderung der Empfangsqualität basierend auf der in dem Empfangsqualitätserkennungsschritt erkannten Empfangsqualität;

einen Steuersignalausgabeschritt (S15-S18, S20-S22) des Ausgebens eines Steuersignals zum Steuern eines Verstärkungsgrades einer Verstärkungseinheit des Tuners, um den Verstärkungsgrad basierend auf der Änderung der erkannten Empfangsqualität anzuheben oder zu verringern,

**dadurch gekennzeichnet, dass**

der Änderungserkennungsschritt (S12, S13, S19) die Änderung der Empfangsqualität nur erkennt, wenn erkannt wird, dass die Empfangsqualität die vorbestimmte Bedingung nicht erfüllt, und

der Steuersignalausgabeschritt (S14) ein Steuersignal zum Steuern des Verstärkungsgrades der Verstärkungseinheit so, dass er konstant bleibt, ausgibt, wenn der Referenzerkennungsschritt erkennt, dass die Empfangsqualität die vorbestimmte Bedingung erfüllt.

**14.** Empfangssteuerverfahren nach Anspruch 13, wobei die Tunereinheit (12) eine Mehrzahl von Verstärkungseinheiten (122, 126) enthält, und das Verfahren weiterhin umfasst:

einen Verstärkungsgradänderungsschritt (S34) des Änderns wenigstens eines Verstärkungsgrades der Mehrzahl von Verstärkungseinheiten nur, wenn erkannt wird, dass die Empfangsqualität die vorbestimmte Bedingung nicht erfüllt, wobei

der Änderungserkennungsschritt (S33, S36, S38, S47) eine Änderung der Empfangsqualität basierend auf einer Änderung des Verstärkungsgrades erkennt; und

der Steuersignalausgabeschritt (S39-S46, S48-S55) ein Steuersignal zum Steuern eines Verstärkungsgrades eines jeden der Mehrzahl von Verstärkungseinheiten der Tunereinheit basierend auf der erkannten Änderung der Empfangsqualität ausgibt.

**15.** Empfangssteuerverfahren nach Anspruch 13 oder 14, wobei

der Empfangsqualitätserkennungsschritt als eine Empfangsqualität einen Fehler von Phasen und Amplituden von in einem empfangenen Signal verstreut angeordneten SP-Signalen gegenüber früher bestimmten Phasen und Amplituden erkennt, wobei die früher bestimmten Phasen und die früher bestimmten Amplituden zu einem Referenz-SP-Signal gehören; und

die vorbestimmte Bedingung erfüllt ist, wenn der von dem EmpfangsqualitätsErkennungsschritt erkannte Fehler Null ist.

**Revendications**

**1.** Circuit de commande de réception comprenant :

une unité de détection de degré de réception (136 ; 141 ; 311) pour détecter un degré de réception d'un signal reçu qui a été reçu par une unité de syntoniseur (12) comprenant une unité d'amplification (122, 126) ;

une unité de détection de niveau de référence (S11 ; S32) pour détecter si le degré de réception détecté par l'unité de détection de degré de réception satisfait une condition prédéfinie, ladite condition prédéfinie indiquant que le degré de réception est meilleur qu'un niveau de référence prédéfini ;

une unité de détection de modification (S12, S13, S19 ; S35, S36, S38, S47) pour détecter une modification du degré de réception sur la base du degré de réception détecté par l'unité de détection de degré de réception ; et une unité de délivrance de signal de commande (S15 à S18, S20 à S22 ; S39 à S46, S48 à S55) pour délivrer un signal de commande en vue de commander un degré d'amplification de l'unité d'amplification de l'unité de syntoniseur afin d'augmenter ou de diminuer le degré d'amplification en fonction de la modification du degré de réception détecté par l'unité de détection de modification,

**caractérisé en ce que**

ladite unité de détection de modification (S12, S13, S19 ; S35, S36, S38, S47) est conçue pour détecter la modification du degré de réception uniquement lorsque le degré de réception est détecté comme ne satisfaisant pas la condition prédéfinie par l'unité de détection de niveau de référence, et ladite unité de délivrance de signal de commande (S15 à S18, S20 à S22 S39 à S46, S48 à S55) est conçue pour délivrer un signal de commande en vue de commander le degré d'amplification de l'unité d'amplification afin qu'il demeure constant, lorsque le degré de réception est détecté comme satisfaisant la condition prédéfinie par l'unité de détection de niveau de référence.

2. Circuit de commande de réception conformément à la revendication 1, dans lequel l'unité de détection de modification (S12, S13, S19) comprend une unité d'opération de différence (S12) pour obtenir une différence entre un degré de réception détecté cette fois et une unité de réception détectée une fois dernière ; une unité de discrimination (S13) pour la discrimination de l'existence de la modification du degré de réception par la discrimination si la différence obtenue est ou non de zéro ; une unité de stockage (S19) pour stocker le degré de réception détecté cette fois en tant que degré de réception détecté la fois dernière une fois que la discrimination a été exécutée par l'unité de discrimination.

3. Circuit de commande de réception conformément à la revendication 2, dans lequel l'unité de délivrance de signal de commande (S14) ne modifie pas le degré d'amplification lorsqu'une discrimination effectuée par l'unité de discrimination indique que le de degré de réception n'est pas modifié.

4. Circuit de commande de réception conformément à la revendication 2, dans lequel l'unité de délivrance de signal de commande (S15 à S18, S20 à S22) comprend une unité d'évaluation de positif/négatif (S15) pour évaluer ce qui est positif et ce qui est négatif dans la différence obtenue par l'unité d'opération de différence lorsqu'une discrimination effectuée par l'unité de discrimination indique que le degré de réception est modifié ; et une unité de commande de degré d'amplification (S16-S17, S20 à S22) pour effectuer la commande du degré d'amplification sur la base d'un résultat d'évaluation de l'unité d'évaluation de positif et de négatif et d'un état du signal de commande délivré en détectant la modification la fois dernière.

5. Circuit de commande de réception conformément à la revendication 4, dans lequel l'unité de commande de degré d'amplification (S16-S17, S20-S21) augmente le degré d'amplification lorsque la différence obtenue par l'unité d'opération de différence est positive et que le signal de commande délivré en détectant la modification la fois dernière est dans un état permettant une commande d'augmentation, et lorsque la différence obtenue par l'unité d'opération de différence est négative et que le signal de commande délivré en détectant la modification la fois dernière est dans un état permettant la commande de diminution, et diminue le degré d'amplification lorsque la différence obtenue par l'unité d'opération de différence est négative et que le signal de commande délivré en détectant la modification la fois dernière est dans l'état permettant la commande de diminution.

6. Circuit de commande de réception conformément à la revendication 5, dans lequel l'unité de commande de degré d'amplification (S18, S22) amène le signal de commande dans un état de mise en oeuvre de la commande d'augmentation lorsque le degré d'amplification a été augmenté, et amène le signal de commande dans un état de mise en oeuvre de la commande de diminution lorsque le degré d'amplification a été diminué.

7. Circuit de commande de réception conformément à l'une quelconque des revendications 1 à 6, dans lequel l'unité de détection de degré de réception (136) détecte une valeur C/N (porteuse sur bruit) du signal reçu.

8. Circuit de commande de réception conformément à l'une quelconque des revendications 1 à 6, dans lequel l'unité de détection de degré de réception (141) détecte une valeur BER (taux d'erreur sur les bits) du signal reçu.

**9.** Circuit de commande de réception conformément à l'une quelconque des revendications 1 à 8, dans lequel ladite unité de syntoniseur (12) comprend une pluralité d'unités d'amplification (122, 126) ; ledit circuit de commande de réception comprenant en outre

une unité de modification de degré d'amplification (S34) pour modifier au moins l'un des degrés d'amplification de la pluralité d'unités d'amplification uniquement lorsque le degré de réception est détecté comme ne satisfaisant pas la condition prédéfinie par l'unité de détection de niveau de référence, dans lequel

ladite unité de détection de modification (S35, S36, S38, S47) est conçue pour délivrer une modification du degré de réception en fonction d'une modification du degré d'amplification par l'unité de modification de degré d'amplification ; et

ladite unité de délivrance de signal de commande (S39 à S46, S48 à S55) est conçue pour délivrer un signal de commande en vue de commander un degré d'amplification de chacune de la pluralité d'unités d'amplification de l'unité de syntoniseur sur la base de la modification du degré de réception détecté par l'unité de détection de modification.

**10.** Circuit de commande de réception conformément aux revendications 2 et 9, dans lequel l'unité de délivrance de signal de commande (S39, S48) est conçue pour commander l'unité de modification de degré d'amplification afin de modifier un degré d'amplification d'une autre unité d'amplification de l'unité de syntoniseur lorsqu'une discrimination effectuée par l'unité de discrimination indique que le degré de réception n'est pas modifié.

**11.** Circuit de commande de réception conformément à l'une quelconque des revendications 1 à 6, dans lequel ladite unité de détection de degré de réception (311) est conçue pour détecter, en tant que degré de réception, une erreur de phases et d'amplitudes appartenant à des signaux SP d'un signal reçu configurés de manière à être dispersé dans celui-ci, à partir de phases et d'amplitudes précédemment déterminés, les phases déterminées précédemment et les amplitudes déterminées précédemment appartenant à un signal SP de référence ;

dans lequel ladite condition prédéfinie est satisfaite, si l'erreur détectée par ladite unité de détection de degré de réception est de zéro.

**12.** Circuit de commande de réception conformément à la revendication 11, dans lequel l'unité de détection de degré de réception (311) détecte une valeur moyenne de rapports de puissance de bruits d'un nombre prédéfini de signaux SP reçus et du signal SP de référence à la puissance de porteuse en tant qu'erreur.

**13.** Procédé de commande de réception comprenant :

une étape de détection de degré de réception pour détecter un degré de réception d'un signal reçu qui a été reçu par une unité de syntoniseur (12) comprenant une unité d'amplification (122, 126) ;

une étape de détection de niveau de référence (S11) pour détecter si le degré de réception détecté satisfait ou non une condition prédéfinie, ladite condition prédéfinie indiquant que le degré de réception est meilleur qu'un niveau de référence prédéfini ;

une étape de détection de modification (S12, S13, S19) pour détecter une modification du degré de réception détecté à l'étape de détection de degré de réception ; et

une étape de délivrance de signal de commande (S15 à S18, S20 à S22) pour délivrer un signal de commande en vue de commander un degré d'amplification d'une unité d'amplification de l'unité de syntoniseur afin d'augmenter ou de diminuer le degré d'amplification sur la base de la modification du degré de réception détecté, **caractérisé en ce que**

ladite étape de détection de modification (S12, S13, S19) détecte la modification du degré de réception uniquement lorsque le degré de réception est détecté comme ne satisfaisant pas la condition prédéfinie, et

ladite étape de délivrance de signal de commande délivre (S14) un signal de commande pour commander le degré d'amplification de l'unité d'amplification afin qu'il demeure constant, lorsque le degré de réception est détecté comme satisfaisant la condition prédéfinie par l'étape de détection de niveau de référence.

**14.** Procédé de commande de réception conformément à la revendication 13, dans lequel ladite unité de syntoniseur (12) comprend une pluralité d'unités d'amplification (122, 126) ; le procédé comprenant en outre

une étape de modification de degré d'amplification (S34) pour modifier au moins l'un des degrés d'amplification de la pluralité d'unités d'amplification uniquement lorsque le degré de réception est détecté comme ne satisfaisant pas la condition prédéfinie, dans lequel

ladite étape de détection de modification (S35, S36, S38, S47) détecte une modification du degré de réception détecté sur la base d'une modification du degré d'amplification ; et

ladite étape de délivrance de signal de commande (S39 à S46, S48 à S55) délivre un signal de commande pour commander un degré d'amplification de chacune de la pluralité d'unités d'amplification de l'unité de syntoniseur sur la base de la modification détectée du degré de réception.

15. Procédé de commande de réception conformément à la revendication 13 ou 14, dans lequel

ladite étape de détection de degré de réception détecte, en tant que degré de réception, une erreur de phases et d'amplitudes appartenant à des signaux SP d'un signal reçu configurés de manière à être dispersés dans ce dernier, à partir de phases et d'amplitudes qui ont été précédemment déterminées, les phases déterminées précédemment et les amplitudes déterminées précédemment appartenant à un signal SP de référence ; et

ladite condition prédéfinie est satisfaite, si l'erreur détectée par ladite étape de détection de degré de réception est de zéro.

# FIG. 1

# FIG. 2

START

S10 — LAST TIME C/N VALUE←
C/N REFERENCE LEVEL
F←1

S11 — C/N>C/N REFERENCE
LEVEL?

YES

NO

S12 — THIS TIME C/N VALUE–
LAST TIME C/N VALUE→
ΔC/N

S13 — ΔC/N=0?

NO

YES

S14 — KEEP AGC VOLTAGE
F←1

S15 — ΔC/N?

ΔC/N<0

ΔC/N>0

S16 — F=0?

YES — ①

NO

S20 — F=1?

NO

① → YES

S21 — INCREASE AGC
VOLTAGE BY α

S17 — DECREASE AGC
VOLTAGE BY α

S22 — F←1

S18 — F←0

S19 — UPDATE LAST TIME C/N
VALUE BY THIS TIME C/N
VALUE

# FIG. 3

FIG. 4

# FIG. 5

START

MODE←0, LAST TIME C/N VALUE←C/N REFERENCE LEVEL F←1 — S30

S31 — MODE=0? — NO

YES

S32 — C/N>C/N REFERENCE LEVEL — NO

YES

S35 — UPDATE LAST TIME C/N VALUE BY THIS TIME C/N VALUE

S33 — KEEP FIRST AGC VOLTAGE AND SECOND AGC VOLTAGE F←1

S34 — INCREASE FIRST AGC VOLTAGE BY $\alpha$ AND KEEP SECOND AGC VOLTAGE MODE←1

S36 — THIS TIME C/N VALUE− LAST TIME C/N VALUE→ $\Delta$C/N

S37 — MODE=1? — NO

YES

S38 — $\Delta$C/N=0? — YES

NO

S40 — $\Delta$C/N>0? — NO

YES

S44 — F=0? — YES — ③

NO

S41 — F=1? — NO

③ → YES

S42 — INCREASE FIRST AGC VOLTAGE BY $\alpha$

S45 — DECREASE FIRST AGC VOLTAGE BY $\alpha$

S39 — KEEP FIRST AGC VOLTAGE AND INCREASE SECOND AGC VOLTAGE BY $\gamma$ MODE←2

S43 — F←1

S46 — F←0

S47 — $\Delta$C/N=0? — YES

NO

S49 — $\Delta$C/N>0? — NO

YES

S51 — F=0? — YES — ④

NO

S50 — F=1? — NO

④ → YES

S52 — INCREASE SECOND AGC VOLTAGE BY $\gamma$

S54 — DECREASE SECOND AGC VOLTAGE BY $\gamma$

S48 — KEEP FIRST AGC VOLTAGE AND SECOND AGC VOLTAGE MODE←0

S53 — F←1

S55 — F←0

# FIG. 6

# FIG. 7

EP 1 665 610 B1

# FIG. 8

# FIG. 9A

# FIG. 9B

# FIG. 10

# FIG. 11

311

FREQUENCY SIGNAL
(CARRIER UNIT)

SYNCHRONOUS DETECTION CIRCUIT — 3111

SYNCHRONIZATION INFORMATION

3112
SP COUNTER CIRCUIT

SP ARRANGEMENT INFORMATION

3115
SP SIGNAL EXTRACTION CIRCUIT

I COMPONENT OF RECEIVED SP SIGNAL

Q COMPONENT OF RECEIVED SP SIGNAL

SP SIGNAL INFORMATION

3113
I, Q INFORMATION READ CIRCUIT

I COMPONENT OF REFERENCE SP SIGNAL

Q COMPONENT OF REFERENCE SP SIGNAL

3116c
3116e
3116
3117

ERROR SUMMARIZATION CIRCUIT

3116a
3116b
3116d

ERROR CALCULATION CIRCUIT

3114
I, Q INFORMATION TABLE

EP 1 665 610 B1

EP 1 665 610 B1

# FIG. 12

START

LAST TIME ERROR←0
F←1 — S60

THIS TIME ERROR=0? — S61
NO →
YES

S62
KEEP AGC VOLTAGE
F←1

S63
THIS TIME ERROR−
LAST TIME ERROR→
ERROR CHANGED
VALUE

S64 — ERROR CHANGED VALUE>0?
NO →
YES

S68 — F=1?
NO → ①
YES

S65 — F=1?
NO →
① → YES

S69
INCREASE AGC
VOLTAGE BY α

S66
DECREASE AGC
VOLTAGE BY α

S67
F←0

F←1 — S70

S71
LAST TIME ERROR←
THIS TIME ERROR

31

# FIG. 13

# FIG. 14

EP 1 665 610 B1

## FIG. 15

EP 1 665 610 B1

# FIG. 16

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2371690 A

- JP TOKUKAI2001102947 A